# EUROPEAN PATENT SPECIFICATION

(11) **EP 2 905 814 B1**
(45) Date of publication and mention of the grant of the patent: **01.04.2020**
(21) Application number: 13844199.3
(22) Date of filing: 30.09.2013
(51) Int. Cl.: H01L 31/0747, H01L 31/18

(54) **METHOD FOR MANUFACTURING CRYSTALLINE SILICON SOLAR CELL, AND METHOD FOR MANUFACTURING SOLAR CELL MODULE**
VERFAHREN ZUR HERSTELLUNG EINER KRISTALLINEN SILICIUMSOLARZELLE, UND VERFAHREN ZUR HERSTELLUNG EINES SOLARZELLENMODULS
PROCÉDÉ DE FABRICATION D'UNE CELLULE SOLAIRE À SILICIUM CRISTALLIN, ET PROCÉDÉ DE FABRICATION D'UN MODULE DE CELLULE SOLAIRE

(30) Priority: 02.10.2012 JP 2012220572; 17.05.2013 JP 2013105528
(43) Date of publication of application: 12.08.2015
(73) Proprietor: Kaneka Corporation, Osaka-shi, Osaka 530-8288 (JP)
(72) Inventor: UZU Hisashi, Settsu-shi Osaka 566-0072 (JP); TERASHITA Toru, Settsu-shi Osaka 566-0072 (JP); ADACHI Daisuke, Settsu-shi Osaka 566-0072 (JP); YOSHIMI Masashi, Settsu-shi Osaka 566-0072 (JP); LUIS HERNANDEZ Jose, B-1160 Brussels (BE)
(74) Representative: Hoffmann Eitle
(86) International application number: PCT/JP2013/076615
(87) International publication number: WO 2014/054600

(56) References cited:
- EP-A2- 1 168 458
- EP-A2- 1 973 168
- WO-A1-2008/062685
- JP-A- H09 129 904
- JP-A- 2001 044 461
- JP-A- 2004 221 368
- JP-A- 2005 236 017
- JP-A- 2006 310 774
- JP-A- 2008 235 604
- JP-A- 2009 246 031
- JP-A- 2012 142 452
- JP-A- 2013 115 057
- US-A- 5 935 344
- US-A1- 2006 219 292

## Description

### TECHNICAL FIELD

The present invention relates to a method for producing a crystalline silicon solar cell and a method for producing a solar cell module.

### BACKGROUND ART

Crystalline silicon solar cells, each using a crystalline silicon substrate, have been already in practical use widely and generally as a photo voltaic system due to their high photoelectric conversion efficiency. Among crystalline silicon solar cells, a crystalline silicon solar cell in which a diffusion potential is formed by depositing an amorphous silicon thin film having a different band gap from that of a single crystalline silicon on a single crystal surface is called a hetero-junction solar cell (see Patent Document 1, for example).

Among hetero-junction solar cells, a solar cell having a thin intrinsic amorphous silicon layer deposited between a conductive type amorphous silicon thin film and a crystalline silicon surface, which are provided in order to form a diffusion potential, is known as one form of crystalline silicon solar cells having the highest conversion efficiency.
The film-formation of a thin intrinsic amorphous silicon layer between a crystalline silicon surface and a conductive type amorphous silicon thin film passivates defects existing on the crystalline silicon surface. Moreover, it prevents carrier-introduced impurities from diffusing into the crystalline silicon surface in forming a conductive-type amorphous silicon thin film.

On the other hand, Patent Document 2 specified below discloses an example of a method for producing a hetero-junction solar cell.
In Patent Document 2, a method is disclosed for producing a photovoltaic device in such a manner that amorphous or microcrystalline semiconductor layers having opposite conductivity-types are respectively provided on both sides of a crystalline semiconductor substrate. Specifically, the semiconductor layer coming to a front surface side is formed on a substantially entire area of the substrate, while the semiconductor layer coming to a back surface side is formed on an area smaller than that of the substrate by masking.
The method for producing a photovoltaic device is considered to reduce a characteristic deterioration caused by a silicon thin film extending around to the front surface and the back surface and to reduce a disabled part.

However, in view of general industrial production, fewer mask processes are more desirable. Specifically, the above-mentioned method for producing a photovoltaic device performs many mask processes, and thus has a problem of being poor in mass productivity. In other words, the method for producing a photovoltaic device described in the Patent Document 2 is unsuited for industrial use.

Additionally, the above-described method for producing a photovoltaic device needs to leave a margin for a mask in view of leak prevention. Specifically, the method for producing a photovoltaic device needs to leave a certain amount of area where a silicon thin film layer is not formed. Thus, a photovoltaic device produced by the method has a problem of a trade-off between current gain and leak loss.

Patent Documents 3 and 4 specified below each propose a method of forming grooves by using a laser beam.

Patent Document 3 discloses a method of preventing a short circuit resulting from the extension of a film by insulation treatment performed by forming grooves reaching an intrinsic amorphous semiconductor layer from a front surface or a back surface.

Conventionally, a commonly used hetero-junction solar cell is one provided with a p-type amorphous semiconductor layer on a light-incident surface of an n-type single crystalline silicon substrate and an n-type amorphous semiconductor layer on a back surface thereof.
Such a kind of hetero-junction solar cell has a problem of a leakage current generation resulting from damage to a p-n interface upon irradiation by a laser beam from the light-coming surface side.
In view of prevention of a leakage current, as disclosed in Patent Document 4, insulation treatment is preferably performed by forming separation grooves through irradiation by a laser beam to the back surface and further cleaving.

Herein, Patent Document 4 discloses a method of forming a back electrode of a comb shape on the back surface and forming the separation grooves through irradiation by a laser beam to an area outside the back electrode.

In addition to the above-mentioned methods, Patent Documents 5 to 7 are specified below as literature describing prior arts relating to the present invention. Further to these, Patent Documents 8 to 11 also relate to the present invention.

Patent Document 8 describes solar cells and methods of their manufacture which reportedly exhibit decreased or eliminated leak current, improved open voltage and improved fill factor characteristics. In the solar cells a separate processed surface is interposed between a first and a second main surface of a crystal substrate, as prepared by laser irradiation and cut processing where the laser irradiation is applied to an amorphous semiconductor layer of the same conductive type as an underlying single crystal substrate, but does not penetrate an underlying amorphous opposite type layer.

Patent Document 9 describes a method for manufacturing a solar cell that includes: forming a dividing groove that reaches an n-type single crystal silicon substrate in a thickness direction of a photoelectric conversion part; and fracturing the photoelectric conversion part along the dividing groove, wherein the dividing groove is formed continuously in an inside of an outer circumference portion of the photoelectric conversion part.

Patent Document 10 describes a method of manufacturing a photovoltaic element that includes a laminated portion including an intrinsic amorphous silicon layer formed on a first main surface of an n-type single crystal silicon substrate and having a trench deep enough to reach at least the intrinsic amorphous semiconductor layer.

Patent Document 11 describes a device in which a photoelectric conversion layer, a transparent electrode layer, an insulating layer, and a back electrode layer are successively formed in this order on a conductive substrate having a through-hole formed therein, and the transparent electrode layer and the back electrode layer are electrically communicated with each other through the through-hole so as to provide a photovoltaic element in which no grid is employed.

### PATENT DOCUMENT

Patent Document 1: JP No. 4152197
Patent Document 2: JP No. 3825585
Patent Document 3: JP No. 3349308
Patent Document 4: JP 2008-235604 A
Patent Document 5: JP 2012-142452 A
Patent Document 6: WO 2008/62685
Patent Document 7: JP 2009-246031 A
Patent Document 8: US 2006/219292 A1
Patent Document 9: EP 1 973 168 A2
Patent Document 10: US 5 935 344
Patent Document 11: EP 1 168 458 A2

### NON -PATENT DOCUMENT

Non-Patent Document 1: C. M. Liu et al. "Journal of The Electrochemical Society," 153 (3) G234-G239 (2005)

### DISCLOSURE OF INVENTION

### TECHNICAL PROBLEM

The hetero-junction solar cell conventionally used is one having collector electrodes formed on the light-incident surface and the back surface. Silver paste (Ag paste) using silver (Ag) is commonly used as a collector electrode.

However, silver paste has a high material cost, and thus, the use of copper (Cu), which is moderate in cost, instead of silver is being actively considered.

It is known that copper has a faster diffusion velocity in silicon than silver. The diffusion of copper into silicon forms an impurity level, resulting in the deterioration of characteristics of solar cells due to the formation of carrier recombination centers.

As a measure against such deterioration of characteristics, Non-Patent Document 1 specified above makes a report in which indium tin oxide (ITO) prevents the diffusion of copper into silicon.

According to the report, it is considered that the hetero-junction solar cell generally has a transparent electrode layer consisting of ITO and others between a silicon substrate and a back electrode, so that the adjustment of a film thickness of the transparent electrode layer prevents the diffusion of copper.

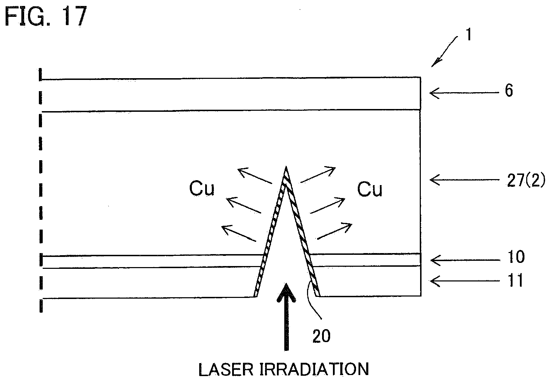

However, even if the film thickness of the transparent electrode layer is closely adjusted, there is a possibility of the following problem:
As shown in Fig. 17, a laser beam is irradiated from a back surface side (back electrode layer 11 side) so as to form a separation groove after the formation of a back electrode layer 11 containing copper, thereby blowing off a copper component contained in the back electrode layer 11. That might diffuse copper (Cu) to the silicon substrate through a surface of the groove as shown by a hatching in Fig. 17.

In other words, the laser beam scatters copper constituting the back electrode layer to the silicon substrate, resulting in bringing copper into contact with the silicon substrate.

Patent Document 3 discloses a method of using a back electrode layer film-formed on an entire area and forming grooves on the light-incident surface or the back surface. However, nothing has been considered about a material of the back electrode layer. That means any problem concerning the use of copper as the back electrode layer has not been considered.

Moreover, the photovoltaic device described in the Patent Document 3 has a groove reaching the intrinsic amorphous semiconductor layer. Thus, when copper (Cu) is used as the back electrode layer, the performance of a damp-heat test makes copper diffuse to the crystalline silicon substrate along the groove, which may supposedly cause a problem of characteristic deterioration of the solar cell. In short, it is considered that the diffusion of copper in an environmental test might deteriorate the characteristics of the solar cell through the surface of the groove.

As described above, insulating treatment in a case of forming copper (Cu) as a back electrode layer has not been discussed in detail in the past.

Therefore, an object of the present invention is to provide a method for producing a crystalline silicon solar cell capable of, even when a back electrode layer containing copper as a major ingredient is used, preventing copper from diffusing to a silicon substrate and suppressing the deterioration of the characteristics of the solar cell after a long time lapse. Another object of the present invention is to provide a method for producing a solar cell module using the method for producing a crystalline silicon solar cell.

### SOLUTION TO THE PROBLEM

The present inventors experimentally produced and evaluated a plurality of crystalline silicon solar cells, each using a back electrode layer containing copper as a major ingredient.

Consequently, the present inventors found that the diffusion of copper into a silicon substrate caused by a laser irradiation was prevented by forming the back electrode layer containing copper (Cu) as a major ingredient on a substantially entire area of a back surface of the substrate and irradiating a laser beam from a front surface (light-incident surface) side. Thereby, the present inventors found that the deterioration of characteristics of the solar cell after a long time lapse was suppressed (retention was maintained).

An aspect of the present invention is a method for producing a crystalline silicon solar cell, wherein the crystalline silicon solar cell includes a one conductivity-type single crystalline silicon substrate, a first main surface, a second main surface, and an outer peripheral part, wherein the substrate has an outer peripheral end face, and wherein the crystalline silicon solar cell further includes (1) a first intrinsic silicon thin film layer, an opposite conductivity-type silicon thin film layer, and a first transparent electrode layer provided on the first main surface side of the substrate in this order, and (2) a second intrinsic silicon thin film layer, a one conductivity-type silicon thin film layer, a second transparent electrode layer, and a back electrode layer provided on the second main surface side of the substrate in this order, the method including the steps of a first transparent electrode layer forming step of forming the first transparent electrode layer on the opposite conductivity-type silicon thin film layer, a back electrode layer forming step of forming the back electrode layer containing moe than 50% copper on the entire area of a surface of the second main surface side of the substrate, and an insulating step of forming an insulating region so as to remove a short circuit between at least the first transparent electrode layer on the first main surface side and at least the second transparent electrode layer and the back electrode layer on the second main surface side after the steps of the first transparent electrode layer forming step and the back electrode layer forming step, the insulating step including a laser irradiation step of irradiating a laser beam along an entire periphery of the outer peripheral part of the first main surface from the first main surface side onto a position within 3 mm from the outer peripheral end face of the one conductivity-type single crystalline silicon substrate, characterized in that (i)the laser irradiation step irradiates the laser beam so as to form a bottomed groove along the entire periphery of the outer peripheral part of the first main surface, wherein the depth of the bottomed groove is one quarter or more of the thickness of the silicon substrate, and the insulating step includes a cleaving step of bending and cleaving to remove an unnecessary part along the bottomed groove after the laser irradiation step; or (ii) the laser irradiation step cuts off an unnecessary part by irradiating the laser beam from the first main surface side to reach the second main surface side, thereby forming the insulating region.

The phrase "containing something (material) as a major ingredient" described herein denotes that the material is contained by more than 50 percent, preferably by 70 percent or more, and more preferably by 90 percent or more. Additionally, the material is not necessarily contained in a single layer and may have a relative ingredient amount contained in a plurality of layers.

Further, the term "one conductivity-type" described herein denotes either an n-type or a p-type. Specifically, the one conductivity-type single crystalline silicon substrate 2 is either an n-type single crystalline silicon substrate or a p-type single crystalline silicon substrate.

According to this aspect, the crystalline silicon solar cell includes the first intrinsic silicon thin film layer, the opposite conductivity-type silicon thin film layer, and the first transparent electrode layer provided on the first main surface side of the one-conductivity-type single crystalline silicon substrate in this order, and the second intrinsic silicon thin film layer, the one conductivity-type silicon thin film layer, the second transparent electrode layer, and the back electrode layer provided on the second main surface side of the one conductivity-type single crystalline silicon substrate in this order.

In sum, according to this aspect, the solar cell has a stacked layer structure in which the first transparent electrode layer, the opposite conductivity-type silicon thin film layer, the first intrinsic silicon thin film layer, the one-conductivity-type single crystalline silicon substrate, the second intrinsic silicon thin film layer, the one conductivity-type silicon thin film layer, the second transparent electrode layer, and the back electrode layer are stacked in this order from the first main surface side to the second main surface side.

In other words, there are provided the silicon thin film layers constituted by the opposite conductivity-type silicon thin film layer, the first intrinsic silicon thin film layer, the one conductivity-type single crystalline silicon substrate, the second intrinsic silicon thin film layer, and the one conductivity-type silicon thin film layer between a first main surface side electrode layer having the first transparent electrode layer and a second main surface side electrode layer having the second transparent electrode layer and the back electrode layer.

Further, this aspect performs the insulating step of forming an insulating region so as to remove a short circuit between at least the first transparent electrode layer on the first main surface side and at least the second transparent electrode layer and the back electrode layer on the second main surface side.

This aspect forms the insulating region so as to remove a short circuit occurring between the first transparent electrode layer serving as an electrode of the crystalline silicon solar cell and the second transparent electrode layer and the back electrode layer serving as counter electrodes of the solar cell due to energization upon driving of the solar cell, thereby preventing a short circuit in power generation.

Further, according to this aspect, the insulating step includes the laser irradiation step of irradiating a laser beam along the entire periphery of the outer peripheral part of the first main surface from the first main surface side onto a position within 3 mm from the outer peripheral end face of the one conductivity-type single crystalline silicon substrate. Specifically, the laser beam is irradiated from the first main surface side located opposite to the second main surface side, where the back electrode layer containing copper as a major ingredient is located. Thereby, the scatter of copper contained in the back electrode layer due to the laser irradiation does not occur or might occur on the opposite side of the one conductivity-type single crystalline silicon substrate, even if that were the case. Consequently, copper does not stick to the substrate, so that the deterioration of the solar cell characteristics after a long time lapse is suppressed.

In a preferred aspect, the method includes performing the first transparent electrode layer forming step, the back electrode layer forming step, and the insulating step in this order.

In a further preferred aspect, the method further includes the steps of a first main surface setting step of setting the one conductivity-type single crystalline silicon substrate on a substrate stage so that a face of the first main surface side is exposed, a first intrinsic silicon thin film layer forming step of forming the first intrinsic silicon thin film layer on the first main surface side, and a first silicon thin film layer forming step of forming the opposite conductivity-type silicon thin film layer, and the first main surface setting step, the first intrinsic silicon thin film layer forming step, the first silicon thin film layer forming step, and the first transparent electrode layer forming step being performed in this order.

The term "substrate stage" described herein denotes a substrate stage of a film forming device such as a CVD device or a sputtering device and is a holding member for holding the substrate in a predetermined position.

This aspect allows a smooth film formation of each layer.

The method includes forming the insulating region so that at least a part of the one conductivity-type single crystalline silicon substrate is exposed.

The insulating step irradiates a laser beam along the entire periphery of the outer peripheral part of the first main surface onto a position within 3 mm from the outer peripheral end face of the one conductivity-type single crystalline silicon substrate, thereby forming the insulating region so that a part of the substrate is exposed. Specifically, the substrate is not coated with any electrode layer on the outside in a planar direction of the substrate, since the insulating region is formed so that the end part in the planar direction (first main surface direction) of the substrate is exposed. In other words, the first transparent electrode layer, the second electrode layer, and the back electrode layer do not coat the substrate on the outside in the planar direction of the substrate. That prevents a short circuit with more certainty.

In one aspect aspect of the inveniton, the laser irradiation step irradiates the laser beam so as to form a bottomed groove along the entire periphery of the outer peripheral part of the first main surface, and the insulating step includes a cleaving step of bending and cleaving to remove an unnecessary part along the bottomed groove after the laser irradiation step.

The term "bottomed groove" described herein denotes a groove having a bottom at least partly continuous to the inner walls of the groove and does not necessarily have a bottom in the whole groove. Specifically, it is only necessary to connect the facing inner walls of the groove via the bottom. In other words, the bottom may be uninterruptedly continuous in an extending direction of the bottomed groove or intermittently continuous.

The term "unnecessary part" described herein denotes a part essentially not contributing to electric generation as a produced solar cell, and specifically, a part having a high possibility of causing a short circuit upon driving the solar cell.

According to this aspect, the laser irradiation step irradiates the laser beam so as to form the bottomed groove along the entire periphery of the outer peripheral part of the first main surface. That means the stacked body constituting the crystalline silicon solar cell is not completely divided.

Herein, in a case where a bottomed groove is formed by laser irradiation from the back surface side, a short circuit may be caused unless the bottomed groove reaches the opposite conductivity-type silicon thin film layer beyond the one conductivity-type single crystalline silicon substrate. Hence, it is necessary to cleave the bottomed groove after the groove formation.

In contrast, when the bottomed groove is formed by laser irradiation from the light-incident surface side as in the present invention, insulation is achieved only when the bottomed groove reaches the one conductivity-type single crystalline silicon substrate. Thus, intrinsically in a sense of insulating, it is achieved only by forming the bottomed groove by laser irradiation from the light-incident surface side as in the present invention. Thus, the cleaving step is not necessarily essential when the laser irradiation is performed from the light-incident surface side.

However, if an unnecessary part remains, leakage current might generate due to some reason such as a contact of tab wires in modularization, for example.

Hence, according to this aspect, the insulating step includes the cleaving step of bending and cleaving to remove the unnecessary part along the bottomed groove after the laser irradiation step. In sum, the bottomed groove is formed by laser irradiation in the above-mentioned laser irradiation step, and then, the insulating region is formed by bending and cleaving with external force applied to the bottom of the bottomed groove in the cleaving step. Since the back electrode layer containing copper as a major ingredient is divided by bending and cleaving, the back electrode layer does not melt due to energy of the laser beam. Consequently, that prevents diffusion of copper with more certainty.

In a second aspect of the inveniton, the laser irradiation step cuts off an unnecessary part by irradiating the laser beam from the first main surface side to reach the second main surface side, thereby forming the insulating region.

According to this aspect, the laser irradiation step irradiates the laser beam from the first main surface side to reach the second main surface side, thereby forming the insulating region. Thus, only the laser beam divides the whole stacked body constituting the crystalline silicon solar cell. That dispenses with the cleaving step and simplifies the steps.

When the insulating step includes the cleaving step, the unnecessary part needs a sufficient width for mechanically cleaving. In contrast, as in this aspect, when dividing is performed only by laser irradiation, the cleaving step can be eliminated, so that the unnecessary part can be minimized. That can enlarge an effective area of a produced solar cell.
In a case of a hetero-junction solar cell, for example, a solar cell is generally formed by using a silicon substrate (silicon wafer) of a substantially square shape.

In producing such a hetero-junction solar cell, according to this aspect, since the laser irradiation step forms the insulating region by irradiating the laser beam so as to reach the second main surface side from the first main surface side, continuous laser irradiation along the entire periphery of the peripheral part (outer peripheral part) of the silicon substrate prevents damages from corners of the silicon substrate, thereby improving productivity.

In a further preferred aspect, the method includes performing a heat treatment step of annealing the insulating region after the insulating step.

This aspect heats the insulating region formed on the end part of the stacked body constituting the crystalline silicon solar cell to a predetermined temperature so as to anneal (annealing). This changes the crystalline structure of a surface of the insulating region, thereby achieving a high degree of crystallinity. Consequently, this improves dimensional stability, physical stability, and chemical stability.

In a further preferred aspect, the method includes forming the back electrode layer by a sputtering method.

This aspect forms the back electrode layer by the sputtering method, thereby forming the back electrode layer with a high particle density and reducing a sheet resistance of the back electrode layer.

Further, in view of productivity, it is preferable to form the first transparent electrode layer and the second transparent electrode layer by the sputtering method, in addition to the back electrode layer. Especially, as to a film-formation order, it is preferable to form the first transparent electrode layer of the light-incident side and the second transparent electrode layer and the back electrode layer of the back surface side in this order, or the second transparent electrode layer and the back electrode layer of the back surface side and the first transparent electrode layer of the light-incident side in this order. The film formation steps in these orders enable the formation of the first transparent electrode layer, the second transparent electrode layer, and the back electrode layer with the common sputtering device, thereby improving productivity.

In a preferred aspect, the method includes forming at least one electrode layer selected from a group consisting of the first transparent electrode layer, the second transparent electrode layer, and the back electrode layer, the at least one electrode layer being provided on one main surface side, so that a part of the at least one electrode layer extends around to the other main surface side.

This aspect forms at least one electrode layer selected from a group consisting of the first transparent electrode layer, the second transparent electrode layer, and the back electrode layer so that a part of the at least one electrode layer extends around to the other main surface side than that where the relevant layer is provided. Specifically, in a case of the first transparent electrode layer, it extends around from the first main surface side to the second main surface side where the second transparent electrode layer and the back electrode layer are located. In a case of the second transparent electrode layer and/or the back electrode layer, they extend around from the second main surface side to the first main surface side where the first transparent electrode layer is located. In any case, the first transparent electrode layer of the first main surface side and the second transparent electrode layer and the back electrode layer of the second main surface side are electrically connected therebetween directly or indirectly, resulting in a short circuit between the electrode layers in energization.

However, because the electrode layer can have a film-formed area set to be large, the electrode layer can be film-formed approximately to the edges, so as to have a good in-plane distribution.

Further, by means of this aspect, a short circuit does not actually occur, because such a part where a short circuit can occur has been removed by the insulating step.

In a more preferred aspect, the method includes forming the back electrode layer in the back electrode layer forming step so that at least a part of the back electrode layer extends around to the first main surface side.

In a preferred aspect, the method includes forming the back electrode layer by a first conductive layer and a second conductive layer containing copper as a major ingredient in this order from the second transparent electrode layer side, wherein the first conductive layer is formed of a conductive material with a high density and formed on a substantially entire area of the surface of the second main surface side of the second transparent electrode layer, and wherein the second conductive layer is formed on a substantially entire area of the surface of the second main surface side of the first conductive layer.

The phrase "conductive material with a high density" described herein denotes one substantially having no spatial gap in the conducting material constituting the first conductive layer in a part where the first conductive layer is formed.

The "conductive material with a high density" is one essentially planarly filled. The term "substantially filled" described herein denotes that the material is filled enough to prevent a migration of metal constituting the second conductive layer to the silicon substrate side and includes material having a pin hole and the like.

The phrase "substantially entire area of the surface of the (first or second) main surface side" described herein denotes a substantially entire area of a reference area (the first main surface or the second main surface) of the relevant surface.

According to this aspect, the first conductive layer is formed of a conductive material with a high density and on a substantially entire area of the surface of the second main surface side of the second transparent electrode layer, and the second conductive layer contains copper as a major ingredient. The first conductive layer is located between the second transparent conductive layer and the second conductive layer.

Further, this aspect uses a conductive material with a high density for the first conductive layer, thereby making a film thickness thinner than that in using a conducting material having a low density, because the material with a high density does not contain impurities such as resin and has a low resistance. Consequently, it is possible to produce a solar cell at lower cost even when the first conductive layer contains silver as a major ingredient, for example. Further, it is thought that an effect that prevents copper diffusion can be expected because of the absence of fine particles or the like, and reflectivity is also increased.

In this way, the first conductive layer formed of a conductive material with a high density prevents the diffusion of copper contained in the second conductive layer as a major ingredient toward the one conductivity-type single crystalline silicon substrate side and further suppresses the deterioration of solar cell characteristics after a long time lapse.

In a preferred aspect, the method includes forming the back electrode layer by stacking the first conductive layer and the second conductive layer in this order from the second transparent electrode layer side, the first conductive layer and the second conductive layer being formed by a same film-forming process, and further includes a first conductive layer forming step of forming the first conductive layer on an outer side of the second transparent electrode layer of the second main surface side of the one conductivity-type single crystalline silicon substrate, and a second conductive layer forming step of forming the second conductive layer on an outer side of the first conductive layer, and the first conductive layer forming step and the second conductive layer forming step being performed continuously in this order.

The term "same film-forming process" described herein denotes the use of the same film-forming method such as a combination of a dry method and another dry method or a combination of a wet method and another wet method. More specifically, it is a combination of a CVD method and another CVD method, a combination of a sputtering method and another sputtering method, or the like. Obviously, film forming materials or formed films may be different.

This aspect performs the first conductive layer forming step and the second conductive layer forming step continuously in this order, so that the film formation can be conducted in the same film-forming device.

In a preferred aspect, the method includes forming the first conductive layer by a sputtering method.

This aspect forms the first conductive layer by the sputtering method, so that the first conductive layer is formed of a conductive material with a high density, which easily forms a precise layer.

A preferred aspect is a method for producing a solar cell module, including a step of forming a crystalline silicon solar cell by the method for producing a crystalline silicon solar cell as described above, and the solar cell module being formed by electrically connecting a plurality of crystalline silicon solar cells in series or in parallel.

This aspect prevents the diffusion of copper to the one conductivity-type single crystalline silicon substrate even when the back electrode layer containing copper as a major ingredient is used, thereby producing a solar cell module in which the deterioration of solar cell characteristics after a long time lapse is suppressed.

Another aspect of the present invention is a method for producing a crystalline silicon solar cell, wherein the crystalline silicon solar cell includes a one conductivity-type single crystalline silicon substrate, a first main surface, a second main surface, and an outer peripheral part, wherein the substrate has an outer peripheral end face, and wherein the crystalline silicon solar cell further includes (1) an opposite conductivity-type silicon thin film layer and a first transparent electrode layer provided on the first main surface side of the substrate in this order, and (2) a one conductivity-type silicon thin film layer, a second transparent electrode layer, and a back electrode layer provided on the second main surface side of the substrate in this order, the method including the steps of a first transparent electrode layer forming step of forming the first transparent electrode layer on an outer side of the opposite conductivity-type silicon thin film layer with respect to the substrate, a back electrode layer forming step of forming the back electrode layer containing copper as a major ingredient on an outer side of the second transparent electrode layer of the second main surface side of the substrate, the back electrode layer forming step forming the back electrode layer on the entire area of the surface of the second main surface side of the second transparent electrode layer, and an insulating step of forming an insulating region so as to physically divide an electrical connection between at least the first transparent electrode layer and at least the second transparent electrode layer and the back electrode layer after the steps of the first transparent electrode layer forming step and the back electrode layer forming step, the insulating step including a laser irradiation step of irradiating a laser beam along an entire periphery of the outer peripheral part of the first main surface from the first main surface side onto a position within 3 mm from the outer peripheral end face of the one conductivity-type single crystalline silicon substrate.

This aspect performs the insulating step of forming the insulating region where an electrical connection between at least the first transparent electrode layer and at least the second transparent electrode layer and the back electrode layer is physically divided. The electrical connection between the first transparent electrode layer serving as an electrode of the crystalline silicon solar cell and the second transparent electrode layer and the back electrode layer serving as the counter electrodes is physically divided, so that a short circuit does not occur during power generation.

Further, according to this aspect, the insulating step includes the laser irradiation step of irradiating a laser beam along the entire periphery of the outer peripheral part of the first main surface from the first main surface side onto a position within 3 mm from the outer peripheral end face of the one conductivity-type single crystalline silicon substrate. Specifically, the laser beam is irradiated from the first main surface side located opposite to the second main surface side where the back electrode layer containing copper as a major ingredient is located. Thereby, the diffusion of copper contained in the back electrode layer due to the laser irradiation does not occur or might occur on the opposite side of the one conductivity-type single crystalline silicon substrate, even if that were the case. Consequently, copper does not stick to the substrate, so that the deterioration of the solar cell characteristics after a long time lapse is suppressed.

The present invention allows for the production of a crystalline silicon solar cell including a one conductivity-type single crystalline silicon substrate, a first main surface, a second main surface, and an outer peripheral part, wherein the substrate has an outer peripheral end face, further including (1) a first intrinsic silicon thin film layer, an opposite conductivity-type silicon thin film layer, and a first transparent electrode layer provided on the first main surface side of the substrate in this order, and (2) a second intrinsic silicon thin film layer, a one conductivity-type silicon thin film layer, a second transparent electrode layer, and a back electrode layer provided on the second main surface side of the substrate in this order, wherein the back electrode layer is formed of a first conductive layer and a second conductive layer in this order from the second transparent electrode layer side, the second conductive layer containing copper as a major ingredient, wherein the second conductive layer is formed on a substantially entire area of a surface of the second main surface side, and wherein the first conductive layer and the second conductive layer have film thicknesses d1 and d2 respectively and satisfy a formula: dl < d2, and further including an insulating region along an entire periphery of the outer peripheral part of the substrate, the insulating region physically dividing an electrical connection between (1) at least the first transparent electrode layer and (2) at least the second transparent electrode layer and the back electrode layer, and the insulating region including a first region extending with inclination from the first main surface side toward the second main surface side, wherein the first region reaches at least the one conductivity-type single crystalline silicon substrate from the first main surface side and has a surface with a laser trace formed.

According to this aspect, at least the second conductive layer is formed on a substantially entire area of the surface of the second main surface side, and the first conductive layer and the second conductive layer have film thicknesses d1 and d2 respectively and satisfy a formula: dl < d2.

Specifically, even if the first conductive layer is formed of a material such as silver, more expensive than copper, the back electrode layer is mostly formed of copper constituting the second conductive layer. That reduces use of a material constituting the first conductive layer, thereby lowering cost.

This aspect includes the insulating region along the entire periphery of the outer peripheral part of the substrate, the insulating region physically dividing an electrical connection between at least the first transparent electrode layer and at least the second transparent electrode layer and the back electrode layer.

Specifically, the insulating region physically dividing the electrical connection between the first transparent electrode layer and the second transparent electrode layer and the back electrode layer is formed so as to remove the short circuit occurring between the first transparent electrode layer serving as an electrode of the crystalline silicon solar cell and the second transparent electrode layer and the back electrode layer serving as counter electrodes thereof due to energization, thereby preventing a short circuit during power generation.

Further, according to this aspect, the insulating region includes a first region extending with inclination from the first main surface side toward the second main surface side, the first region reaching at least the one conductivity-type single crystalline silicon substrate from at least the first main surface side and having a surface with a laser trace formed.

Since the first region extends with inclination from the first main surface side to the second main surface side, the laser beam forming the laser trace is irradiated from the first main surface side located opposite to the second main surface side where the back electrode layer containing copper as a major ingredient is located in a case where the laser beam is, for example, the Gaussian beam.

Thereby, the diffusion of copper contained in the back electrode layer due to the laser irradiation does not occur or might occur on the opposite side of the one conductivity-type single crystalline silicon substrate, even if that were the case. Consequently, copper does not stick to the substrate, so that the deterioration of the solar cell characteristics after a long time lapse is suppressed.

Herein, the "Gaussian beam" is a beam having a light intensity of Gaussian distribution (normal distribution) in a radial direction.

In a preferred aspect, the first region reaches the second main surface side from the first main surface side.

According to this aspect, the insulating region penetrates through the first main surface side to the second main surface side, so that the layer is divided into plural parts without a separate step.

In a preferred aspect, the insulating region includes the first region and a second region, the second region being continuous to the first region and extending to the second main surface side of the solar cell, wherein the second region reaches from the second main surface side of the solar cell to at least the first conductive layer and has a surface roughness different from that of the first region.

According to this aspect, the insulating region is constituted by the first region and the second region. The second conductive layer containing copper as a major ingredient is not provided on the first region where the laser trace is formed, while the end part of the second conductive layer is located on the second region having a surface roughness different from that of the first region.

The second region is formed by a different forming method from that of the first region, and whereby the second conductive layer is protected from melting and diffusing by the laser beam.

In a preferred aspect, the first conductive layer is formed of a conductive material with a high density.

According to this aspect, the first conductive layer formed of a conductive material with a high density more prevents copper contained in the second conductive layer as a major ingredient from diffusing to the one conductivity-type single crystalline silicon substrate side and further suppresses the deterioration of the solar cell characteristics after a long time lapse.

In a preferred aspect, the first main surface of the solar cell is smaller in area than the second main surface of the solar cell.

In a preferred aspect, the first conductive layer is slower in diffusion velocity than the second conductive layer.

According to this aspect, the first conductive layer is slower in diffusion velocity than the second conductive layer, and whereby copper is prevented from diffusing to the one conductivity-type single crystalline silicon substrate.

In a preferred aspect, the first conductive layer contains silver as a major ingredient.

This aspect prevents copper from diffusing to the one conductivity-type single crystalline silicon substrate and also enables the lowering of resistance.

Also disclosed herein is a solar cell module including the crystalline silicon solar cell as described above and including a sealing member for sealing the solar cell module.

This aspect seals the solar cell module by the sealing member, thereby forming a solar cell module with high sealing properties.

### ADVANTAGEOUS EFFECT OF THE INVENTION

The method for producing a crystalline silicon solar cell of this invention is provided with the back electrode layer formed of copper (Cu) and irradiates a laser beam from the front surface side (first main surface side), thereby preventing copper (Cu) from diffusing into the silicon substrate due to laser irradiation, thus enabling to produce a crystalline silicon solar cell with a high retention at low cost.

Further, the method of this invention can provide a crystalline silicon solar cell and a solar cell module with excellent solar cell characteristics, even when the back electrode contains copper as a major ingredient.

### BRIEF DESCRIPTION OF DRAWINGS

Fig. 1 is a schematically-illustrated cross section of a crystalline silicon solar cell which can be prepared according to the method of the present invention;
Fig. 2 is a schematically-illustrated plan view of the crystalline silicon solar cell in Fig. 1, with its outer peripheral part hatched;
Fig. 3 is a cross-sectional perspective view of a region A in Fig. 2;
Figs. 4A to 4E are explanatory diagrams of a method for producing the crystalline silicon solar cell in Fig. 1, each being a cross section of a respective step, without hatching to facilitate understanding;
Figs. 5F to 5I are explanatory diagrams of the method for producing the crystalline silicon solar cell in Fig. 1, each being a cross section of a respective step, without hatching to facilitate understanding;
Fig. 6 is an explanatory diagram showing a state in Fig. 5I and a schematically-illustrated cross section of a part near an end;
Fig. 7 is a schematically-illustrated perspective view showing a laser irradiation step;
Fig. 8 is a plan view of a substrate after the laser irradiation step;
Figs. 9A and 9B are explanatory diagrams showing an insulating step, Fig. 9A being a cross section after the laser irradiation step and Fig. 9B being a cross section after a cleaving step, without hatching to facilitate understanding;
Fig. 10 is an exploded perspective view of a solar cell module prepared according to the first embodiment of the present invention with a sealing material omitted;
Fig. 11 is a cross-sectional perspective view of an end part of a solar cell module prepared according to a second embodiment of the present invention;
Fig. 12 is an explanatory diagram showing an insulating step in the second embodiment and a cross section after a laser irradiation step, without hatching to facilitate understanding;
Figs. 13A and 13B are explanatory diagrams of a crystalline silicon solar cell in Example 1, Fig. 13A being scanning electron micrographs and Fig. 13B being traced drawings of Fig. 13A;
Figs. 14A and 14B are explanatory diagrams of a crystalline silicon solar cell in Comparative Example 1, Fig. 14A being scanning electron micrographs and Fig. 14B being traced drawings of Fig. 14A;
Figs. 15A and 15B are explanatory diagram of a crystalline silicon solar cell in Example 1, Fig. 15A being scanning electron micrographs and Fig. 15B being traced drawings of Fig. 15A;
Figs. 16A and 16B are explanatory diagrams of a crystalline silicon solar cell in Comparative Example 1, Fig. 16A being scanning electron micrographs and Fig. 16B being traced drawings of Fig. 16A; and
Fig. 17 is a schematic cross section showing how Cu diffuses in a laser irradiated portion relating to the Comparative Examples in the present invention.

### EMBODIMENTS OF THE INVENTION

Now, preferred embodiments of the present invention will be described in detail below, making reference to the drawings. In each drawing of this invention, a dimension relation such as a relation between a thickness and a length is appropriately modified for concretization and simplification of the drawing and is not an actual one.

A crystalline silicon solar cell 1 that can be prepared according to the method of the present invention will be described below. It is to be understood that the appended claims are directed to a method for producing a crystalline silicon solar cell or a method for producing a solar cell module.

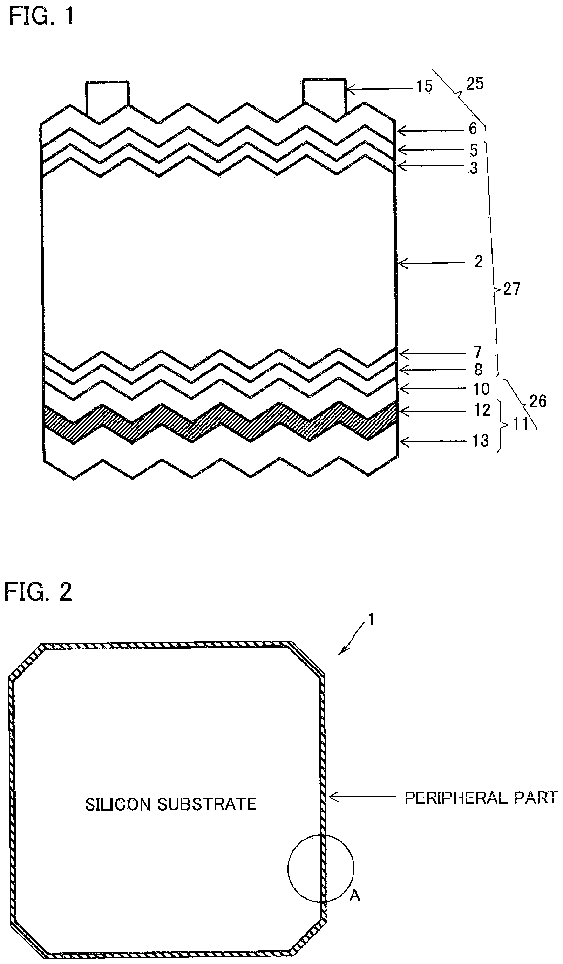

Because the crystalline silicon solar cell 1 in the first embodiment, as shown in Fig. 1, forms a texture structure (concave/convex structure), its film thickness denotes a film thickness in a direction vertical to an inclined surface of a texture on a one conductivity-type single crystalline silicon substrate 2 (hereinafter also simply referred to a "silicon substrate 2") in the following description, unless otherwise noted. When the silicon substrate 2 is flat, it obviously denotes a thickness in a direction perpendicular to a main surface. The following description also refers to a first main surface as a light-incident surface and a second main surface as a back surface.

Referring to Fig. 1, the crystalline silicon solar cell 1 has a first intrinsic silicon thin film layer 3, an opposite conductivity-type silicon thin film layer 5 (light-incident side silicon thin film layer), and a first transparent electrode layer 6 (light-incident side transparent electrode layer) stacked in this order on the first main surface side (light-incident side) of a one conductivity-type single crystalline silicon substrate 2. Further, the crystalline silicon solar cell 1 is provided with collector electrodes 15 on the first main surface side (light-incident side) of the first transparent electrode layer 6.

On the other hand, the crystalline silicon solar cell 1 has a second intrinsic silicon thin film layer 7, a one conductivity-type silicon thin film layer 8 (back surface side silicon thin film layer), a second transparent electrode layer 10 (back surface side transparent electrode layer), and a back electrode layer 11 (back electrode) stacked in this order on the second main surface side (back surface side) of the silicon substrate 2. The back electrode layer 11 is formed by a first conductive layer 12 and a second conductive layer 13 stacked in this order from the second transparent electrode layer 10 side. Further, the back electrode layer 11 is provided with a protection layer not shown on the second main surface side (back surface side).

In other words, the crystalline silicon solar cell 1 in this embodiment, as shown in Fig. 1, includes a first main surface-side electrode layer 25 constituted by the first transparent electrode layer 6 and the collector electrodes 15 and a second main surface-side electrode layer 26 constituted by the second transparent electrode layer 10 and the back electrode layer 11. Between the first main surface-side electrode layer 25 and the second main surface-side electrode layer 26, there exists a photoelectric conversion section 27 constituted by the opposite conductivity-type silicon thin film layer 5, the first intrinsic silicon thin film layer 3, the silicon substrate 2, the second intrinsic silicon thin film layer 7, and the one conductivity-type silicon thin film layer 8.

In other words, in the crystalline silicon solar cell 1, as shown in Fig. 1, the first intrinsic silicon thin film layer 3 is located at the light-incident side (first main surface side) of the silicon substrate 2 between the silicon substrate 2 and the opposite conductivity-type silicon thin film layer 5. Further, in the crystalline silicon solar cell 1, the second intrinsic silicon thin film layer 7 is located at a light reflection side (second main surface side) of the silicon substrate 2 between the silicon substrate 2 and the one conductivity-type silicon thin film layer 8.

The crystalline silicon solar cell 1 is provided with the first transparent electrode layer 6 on the opposite conductivity-type silicon thin film layer 5 of the light-incident side and the second transparent electrode layer 10 on the one conductivity-type silicon thin film layer 8 of the back surface side.

Now, a configuration of each layer of the crystalline silicon solar cell 1 will be described below.

Firstly, the one conductivity-type single crystalline silicon substrate 2, being central to the crystalline silicon solar cell 1, will be described.

The one conductivity-type single crystalline silicon substrate 2 is formed by rendering a single crystalline silicon substrate electrically conductive.

Specifically, the one conductivity-type single crystalline silicon substrate 2 is formed by adding impurities that supply an electrical charge to silicon constituting a single crystalline silicon substrate so as to render the single crystalline silicon substrate electrically conductive.

The single crystalline silicon substrate that is rendered electroconductive has an n-type and a p-type, the n-type being formed by supplying phosphorus atoms for introducing electrons into Si atoms (silicon atoms) and the p-type being formed by supplying boron atoms for introducing holes (positive holes) into Si atoms.

In a case where the single crystalline silicon substrate that is rendered electrically conductive is used for a solar cell, a hetero junction on the light-incident side, where light incoming to the single crystalline silicon substrate is absorbed the most, is made a reverse junction so as to generate a strong electric field, whereby electron-hole pairs are efficiently separated and recovered.

Therefore, in this view, the hetero junction on the light-incident side is preferably made to be a reverse junction.

Comparing a hole with an electron, the latter, which is smaller in effective mass and in scattering cross-section than the former, generally has a high mobility.

The silicon substrate 2 may be basically either an n-type single crystalline silicon substrate or a p-type single crystalline silicon substrate, but in view of the fact described above, the silicon substrate 2 in this embodiment employs an n-type single crystalline silicon substrate.

The silicon substrate 2 preferably has a surface with a texture structure in view of optical confinement.

Herein, in the silicon substrate 2 in this embodiment, as shown in Fig. 1, the light-incident surface (surface of the first main surface side) and the back surface (surface of the second main surface side) are formed in a texture structure (concave/convex structure).

The opposite conductivity-type silicon thin film layer 5 is a conductivity-type silicon thin film layer having different carriers performing electrical conduction from those of the silicon substrate 2.

Herein, the term "conductivity-type silicon thin film layer" denotes one conductivity-type or the opposite conductivity-type silicon thin film layer.

When the silicon substrate 2 is of an n-type, for example, the one conductivity-type silicon thin film layer 8 becomes of an n-type, whereas the opposite conductivity-type silicon thin film layer 5 becomes of a p-type.

In other words, when the one conductivity-type single crystalline silicon substrate 2 is of an n-type, the opposite conductivity-type silicon thin film layer 5 becomes of a p-type, whereas when the one conductivity-type single crystalline silicon substrate 2 is of a p-type, the opposite conductivity-type silicon thin film layer 5 becomes of an n-type.

Since this embodiment, as described above, employs the n-type silicon substrate 2, the opposite conductivity-type silicon thin film layer 5 is a p-type conductivity-type silicon thin film layer.

A dopant gas such as B₂H₆ or PH₃ can be preferably used for forming a p-type or an n-type silicon thin film constituting the opposite conductivity-type silicon thin film layer 5.

Further, a mixed gas diluted by adding SiH₄ or H₂ in advance is preferably used because a small amount of impurities such as P (phosphorus) or B (boron) to be added is enough. Alternatively, a gas containing a heteroelement (heterogeneous element) such as CH₄, CO₂, NH₃, or GeH₄ can be added to a film-forming gas, thereby making an alloy and changing an energy gap.

A silicon thin film constituting the opposite conductivity-type silicon thin film layer 5 includes an amorphous silicon thin film and a microcrystalline silicon thin film (thin film containing amorphous silicon and crystalline silicon). Among them, it is preferable to use an amorphous silicon thin film. Alternatively, the silicon thin film may employ a conductivity-type silicon thin film.

In this embodiment, as shown in Fig. 1, the opposite conductivity-type silicon thin film layer 5 is situated on the light-incident side (first main surface side) of the silicon substrate 2.

On the light-incident surface side of the silicon substrate 2, this is to suppress recombination loss by generating a strong electric field gradient to the light-incident surface side, because electron excitation by incoming light is obtained the most on the light-incident surface side of the one conductivity-type single crystalline silicon substrate 2.

Further, in this embodiment, in order to suppress recombination on the back surface side (second main surface side), as shown in Fig. 1, the one conductivity-type silicon thin film layer 8 is located on the opposite side of the opposite conductivity-type silicon thin film layer 5 with the silicon substrate 2 interposed.

When an n-type single crystalline silicon substrate is used as the one conductivity-type single crystalline silicon substrate 2, for example, one of the suitable structures includes a transparent electrode layer/ a p-type amorphous silicon thin film/ an i-type amorphous silicon thin film/ an n-type single crystalline silicon substrate/ an i-type amorphous silicon thin film/ an n-type amorphous silicon thin film/ a transparent electrode layer. In this case, for the reasons described above, it is preferable to use an n layer as the conductivity-type silicon thin film layer of the back surface side.

A p-type silicon thin film layer constituting the opposite conductivity-type silicon thin film layer 5 in this embodiment is preferably at least one kind selected from a group consisting of a p-type hydrogenated amorphous silicon layer, a p-type amorphous silicon carbide layer, and a p-type oxide amorphous silicon layer.

The opposite conductivity-type silicon thin film layer 5 is preferably a p-type hydrogenated amorphous silicon layer in view of impurity diffusion and series resistance.

Alternatively, a p-type amorphous silicon carbide layer, or a p-type amorphous silicon oxide layer, is preferably used as the opposite conductivity-type silicon thin film layer 5 in view of reducing optical loss as a low refraction index layer having a wide gap.

The intrinsic silicon thin film layers 3 and 7 (intrinsic silicon thin films), located at both outer surfaces in a thickness direction of the silicon substrate 2, each employ an essentially intrinsic i-type silicon thin film.

It is preferable to use an i-type hydrogenated amorphous silicon constituted by silicon and hydrogen as the intrinsic silicon thin film layers 3 and 7 in this case.

When a film formation is performed by a CVD method by using an i-type hydrogenated amorphous silicon as the intrinsic silicon thin film layers 3 and 7, surface passivation is effectively performed with suppression of impurity diffusion to the silicon substrate 2.

This is because the alteration of hydrogen quantity in the film gives a valid profile in performing carrier recovery in the energy gap.

The one conductivity-type silicon thin film layer 8 (silicon thin film of the back surface side) located on the outer side (second main surface side) of the intrinsic silicon thin film layer 7 is a conductivity-type silicon thin film layer having the same carriers (holes and electrons) performing electrical conduction as those of the silicon substrate 2.

Specifically, in a case where the one conductivity-type single crystalline silicon substrate 2 is of an n-type, the one conductivity-type silicon thin film layer 8 is of an n-type, whereas when the one conductivity-type single crystalline silicon substrate 2 is of a p-type, the one conductivity-type silicon thin film layer 8 is of a p-type.

In this embodiment, since the silicon substrate 2 is of an n-type as described above, the one conductivity-type silicon thin film layer 8 is a conductivity-type silicon thin film layer of an n-type.

In sum, the carriers (holes and electrons) performing electrical conduction of the one conductivity-type silicon thin film layer 8 are different from those of the opposite conductivity-type silicon thin film layer 5.

The one conductivity-type silicon thin film layer 8 (silicon thin film of the back surface side) has the same carriers performing electrical conduction as those of the silicon substrate 2, which has an effect of suppressing recombination of holes and electrons on the back surface side mainly due to a BSF (Back Surface Field) effect.

The one conductivity-type silicon thin film layer 8 preferably has at least an amorphous silicon thin film.

Further, a crystalline silicon thin film may be arranged between the amorphous silicon thin film and the second transparent electrode layer 10 of the back surface side so as to provide good electrical contact with the second transparent electrode layer 10 of the back surface side.

Specifically, the one conductivity-type silicon thin film layer 8 may employ a multilayer structure, which is a stacked structure, by depositing an amorphous silicon thin film and a crystalline silicon thin film in order from the light-incident side (silicon substrate 2 side) to the second transparent electrode layer 10 side.

Herein, the term "crystalline" includes not only a perfect crystalline state but also a partially amorphous state, as generally used in a technical field of thin film photoelectric conversion devices.

In this situation, the one conductivity-type silicon thin film layer 8 needs to have a certain level of thickness so as to obtain a sufficient BSF effect.

That prevents the diffusion of minority carriers (holes in a case where an n-type single crystalline silicon substrate is used as the silicon substrate 2) to the back electrode layer 11 side and suppresses the recombination of the holes and the electrons on the back surface side.

At the same time, the one conductivity-type silicon thin film layer 8 of the back surface side also has a function of preventing metal used as a part of or the entire part of the back electrode layer 11 from diffusing to the one conductivity-type single crystalline silicon substrate 2.

In sum, the crystalline silicon solar cell 1 in this embodiment, the second transparent electrode layer 10 prevents metal used as the back electrode layer 11 from diffusing to the silicon substrate 2. Additionally, a further diffusion prevention effect can be expected from the one conductivity-type silicon thin film layer 8 described above, even when the crystalline silicon solar cell 1 has an area where the second transparent electrode layer 10 is thin or does not partly exist.

In view of further suppressing the diffusion of metal used as a part of the back electrode layer 11 to the crystalline silicon substrate as described above, it is preferable to thicken a thickness of the one conductivity-type silicon thin film layer 8 to some extent.

In this case, the thickness of the one conductivity-type silicon thin film layer 8 is preferably 5 nm or more, more preferably 10 nm or more, and the most preferably 30 nm or more, considering the above-mentioned BSF effect to be obtained.

In contrast, though the upper limit of the thickness of the one conductivity-type silicon thin film layer 8 has not been particularly limited, it is preferably 100 nm or less, more preferably 70 nm or less, and the most preferably 50 nm or less, in view of reducing production cost.

Though the one conductivity-type silicon thin film layer 8 may be within the above-mentioned range in thickness, the intrinsic silicon thin film layers 3 and 7 (essentially intrinsic i-type silicon thin film layers), the opposite conductivity-type silicon thin film layer 5 (p-type silicon thin film layer), and the one conductivity-type silicon thin film layer 8 (n-type silicon thin film layer) each is preferably within a range in thickness of 3 to 20 nm in view of the fact described below.

Within this range, each layer is much smaller than a size (µm order) of the texture structure (convex/concave structure) of the silicon substrate 2. Thus, the opposite conductivity-type silicon thin film layer 5 (p-type silicon thin film layer) and the one conductivity-type silicon thin film layer 8 (n-type silicon thin film layer), located on the outer side in a direction of the deposited layers, have more or less the same surface shape as that of the silicon substrate 2, as shown in Fig. 1. In other words, the surfaces of these stacked bodies each can have a texture structure (convex/concave structure) following the surface shape of the silicon substrate 2.

The film-forming methods of the silicon thin film layers 3, 5, 7, and 8 each are preferably performed by a plasma CVD method.

The first transparent electrode layer 6 and the second transparent electrode layer 10 are layers containing conductive oxide as a major ingredient.

As the conductive oxide, for example, zinc oxide, indium oxide, or tin oxide may be used as a single agent or in combination, but in view of conductivity, optical characteristics, and long-term reliability, an indium-based oxide containing indium oxide is preferably used. Among them, one containing indium tin oxide (ITO) as a major ingredient is more preferably used.

Herein, in this invention, the phrase, "containing a material as a major ingredient" denotes that the material is contained by more than 50 percent, preferably by more than 70 percent, and more preferably by more than 90 percent.

The transparent electrode layers 6 and 10 each may be a single layer or a stacked structure constituted by a plurality of layers. Further, a doping substance can be added to each of the transparent electrode layers 6 and 10.

In a case where zinc oxide is used for the transparent electrode layers 6 and 10, for example, the doping substance includes aluminum, gallium, boron, silicon, and carbon.

In a case where indium oxide is used for the transparent electrode layers 6 and 10, the doping substance includes zinc, tin, titanium, tungsten, molybdenum, and silicon.

In a case where tin oxide is used for the transparent electrode layers 6 and 10, the doping substance includes fluorine.

Though, as described above, the doping substance can be added to either or both of the first transparent electrode layer 6 and the second transparent electrode layer 10 as shown in Fig. 1, it is preferable to add it to the first transparent electrode layer 6 (light-incident side transparent electrode layer).

This is to suppress resistance loss that may be generated in the first transparent electrode layer 6, since the collector electrodes 15 formed on the light-incident side are generally of a comb shape.

The first transparent electrode layer 6 located on the light-incident side preferably has a film thickness within a range of 10 nm to 140 nm in view of transparency, electrical conductivity, and light reflection reduction of the cells.

One of functions of the first transparent electrode layer 6 is a conveyance of carriers to the collector electrodes 15, and thus, any thickness that provides the required electrical conductivity is appropriate.

However, in view of transparency, a thickness of 140 nm or less brings about a smaller absorption loss of the first transparent electrode layer 6, thereby suppressing a reduction in photoelectric conversion efficiency caused by the lowering of a transmittance.

Further, a lowered carrier concentration in the first transparent electrode layer 6 suppresses a reduction in photoelectric conversion efficiency caused by an increase in light absorption in an infrared region.

Still further, the first transparent electrode layer 6 also functions as an antireflection film, so that a light confinement effect can be expected by being set to an appropriate film thickness of the layer 6.

Meanwhile, the second transparent electrode layer 10 located on the back surface side is important with respect particularly to preventing the diffusion of metal (copper in this embodiment), which is used for the second conductive layer 13 as a part of the back electrode layer 11, to the silicon substrate 2 in addition to an effect of increase in a back surface reflection. Particularly, in the crystalline silicon solar cell 1 in this embodiment, as described below, the first conductive layer 12 is formed of metal having a slower diffusion velocity than copper, which might diffuse to the silicon substrate 2, though causing less diffusion than copper.

In view of the above-mentioned prevention of metal diffusion, a thickness of the second transparent electrode layer 10 is of preferably 5 nm or more, more preferably 10 nm or more, and further more preferably 30 nm or more.

In view of suppressing light absorption, or suppressing decreases in electric current (Jsc) caused by a long wavelength light absorption, a thickness of the second transparent electrode layer 10 is of preferably 180 nm or less, more preferably 150 nm or less, further more preferably 110 nm or less, and most preferably 90 nm or less.

Arranging the film thickness of the second transparent electrode layer 10 within the above-mentioned range prevents diffusion of metal used for "the back electrode layer." In a case where the first conductive layer 12 is provided in the back electrode layer 11, as shown in this embodiment, though diffusion of metal used for the first conductive layer 12 may occur, the second transparent electrode layer 10 prevents the metal diffusion.

Further, potential diffusion of copper constituting the second conductive layer 13 (second electrode layer), caused when the first conductive layer 12 is partly thin or no first conductive layer 12 exists, is also prevented by the arrangement of the film thickness of the second transparent electrode layer 10 within the above mentioned range. In sum, a diffusion prevention effect can be more expected by the arrangement of the film thickness of the second transparent electrode layer 10 within the above-mentioned range.

The film-forming method of the transparent electrode layers 6 and 10 is not particularly limited, but is preferably a physical vapor deposition method such as a sputtering method, a chemical vapor deposition (MOCVD) method through reaction with organometallic compound and oxygen or water, and so on. Energy by heat or plasma discharge can also be used in any film-forming method.

A substrate temperature when the transparent electrode layers 6 and 10 are formed may be appropriately set, and it is preferably 200 degrees centigrade or less in a case where an amorphous silicon thin film is used for any one of the silicon thin film layers 3, 5, 7, and 8.

Film formation at 200 degrees centigrade or less suppresses hydrogen removal from the amorphous silicon layer and generation of dangling bond (Dangling Bond) in a silicon atom followed by removal, thereby ensuring the improvement of conversion efficiency as a consequence.

As described above, the back electrode layer 11 is formed on the second transparent electrode layer 10. Specifically, the back electrode layer 11 is, as shown in Fig. 1, constituted by the first conductive layer 12 and the second conductive layer 13 in order from the second transparent electrode layer 10 side.

In this embodiment, the second conductive layer 13 contains copper as a major ingredient. Furthermore, the first conductive layer 12 has a function of preventing the diffusion of metal (copper) to the silicon substrate 2.

Therefore, though the arrangement of the film thickness of the second transparent electrode layer 10 prevents the diffusion of copper contained in the second conductive layer 13 even without the first conductive layer 12 as described above, the introduction of the first conductive layer 12 further prevents the copper diffusion. Alternatively, even when the second transparent electrode layer 10 is thin without the above-mentioned range, the first conductive layer 12 prevents the diffusion of copper contained in the second conductive layer 13.

More specifically, it is preferable that the first conductive layer 12 is formed of a conductive material having high density and formed on a substantially entire area of a surface of the second main surface side of the second transparent electrode layer 10.

Herein, the phrase "conductive material having high density" denotes that a conductive material constituting the first conductive layer 12 has substantially no spatial gap produced therein at a portion where the first conductive layer 12 is formed. Shortly, "the conductive material having high density" is a material filled essentially in a plane.

Herein, the term "filled essentially" denotes that the material is filled to prevent migration of metal constituting the second conductive layer 13 to the silicon substrate 2 side and includes the material having a pinhole formed therein.

In a case of a material having metal fine particles such as a paste material, for example, the metal fine particles contain resin and the like therebetween, which means spatial gaps exist between the metal fine particles. Thus, such a kind of material does not meet the definition of a "conductive material having high density."

In contrast, a film formed by a method such as a sputtering method has mostly no special gap in the conductive material contained in the first conductive layer 12, thereby meeting the definition of a "conductive material having high density."
Further, a metal alone and an alloy each also meet the definition of a "conductive material having high density."

Herein, the phrase "formed on a nearly entire area" denotes that 90 percent or more of a reference surface are covered.

Specifically, the phrase "the first conductive layer 12 is formed on a nearly entire area of a surface of the second main surface side of the second transparent electrode layer 10" denotes that 90 percent or more of the surface of the second main surface side of the second transparent electrode layer 10 are covered with the first conductive layer 12.
At this time, it is preferable that the first conductive layer 12 is formed in a region where the second conductive layer 13 is formed.

Among them, it is preferable to cover 90 percent or more, more preferable to cover 95 percent or more, and most preferable to cover 100 percent, or an entire area.
In this case, a diffusion prevention effect of metal (copper, specifically) contained in the second conductive layer 13 can be expected. Further, it is preferable in view of the easiness of film formation.

Now, a case of using a conductive material having low density such as a resin paste for the first conductive layer 12 will be described below. In this case, the first conductive layer has a higher resistance than in a case where a material such as pure metal is used, resulting in the need to thicken the film thickness to some extent.
In this embodiment, as described above, the first conductive layer 12 is formed of a conductive material having high density, so as to have lower resistance than the layer containing the resin paste because no impurity, such as resin, is contained. That makes the film thickness thinner.

Consequently, the use of the first conductive layer 12 containing a material such as silver as a major ingredient, for example, also achieves production at low cost. Further, with no impurity such as fine particles, a diffusion prevention effect of copper can be expected and high reflectance would be expected.

In view of the fact described above, the first conductive layer 12 can be formed of a material such as resin paste, but is preferably formed of a conductive material having high density.

The first conductive layer 12 and the second conductive layer 13 in this embodiment preferably have respective film thicknesses d1 and d2 that satisfy dl < d2.

The film thickness dl of the first conductive layer 12 is preferably 8 nm or more. An increased current due to a back surface reflection can be expected by the arrangement of dl of 8 nm or more.

Among them, in view of improving reflectivity and reliability by entirely covering the surface of the second main surface side of the second transparent electrode layer 10, the film thickness dl of the first conductive layer 12 is preferably 20 nm or more, more preferably 30 nm or more, and further more preferably 40 nm or more.

Further, in view of cost reduction, the film thickness dl is preferably 100 nm or less, more preferably 80 nm or less, further more preferably 70 nm or less, and most preferably 60 nm or less.
The film thickness of the second conductive layer 13, being made larger than the film thickness of the first conductive layer 12 (i.e., dl < d2), reduces an amount of a material used for the first conductive layer 12.

The first conductive layer 12 is preferably formed of a material with a high reflectivity in an infrared to near-infrared region, a high electrical conductivity, and an excellent chemical stability.

Since the second conductive layer 13 contains copper as a major ingredient, the first conductive layer 12 needs to be formed of a material having a slower diffusion velocity to crystalline silicon than that of copper.

The materials satisfying such characteristics include silver, gold, and aluminum. Among them, in view of reflectivity and electrical conductivity, the first conductive layer 12 is preferably formed of a material containing silver or gold as a major ingredient, more preferably formed of a material containing silver as a major ingredient, and most preferably formed of silver. In this embodiment, the material of the first conductive layer 12 is silver.

For reference, Table 1 shows a transmittance of a sample in which silver is formed on a glass substrate by a sputtering method. In Table 1, transmittance values are shown when a wavelength is altered from 900 to 1200 nm and a film thickness of silver is altered from 10 to 250 nm.

According to Table 1, the transmittance is lowered as the film thickness of silver is thickened.

From the fact that the reflectance is increased as the transmittance is lowered, it is considered that the reflectance is increased as the film thickness of silver is thickened.

Especially, a film thickness of silver of about 25 nm or more shows sufficiently high reflectance. A film thickness of about 50 nm or more shows a transmittance value of about 0.02, and the reflectance is thought to be about the same level.

Consequently, when silver is particularly used for the first conductive layer 12 as a major ingredient, in view of cost of materials, it is preferable to render the film thickness of the first conductive layer 12 as thin as possible, but it is more preferable to be about 25 nm or more in view of the reflectance.

### [Table 1]

**TABLE 1**

| TRANSMITTANCE (%) | | FILM THICKNESS OF SILVER (nm) | | | | |
|---|---|---|---|---|---|---|
| | | 250 | 100 | 50 | 25 | 10 |
| WAVE LENGTH (nm) | 900 | 0.01 | 0.02 | 0.01 | 0.61 | 6.62 |
| | 1000 | 0.02 | 0.03 | 0.02 | 0.39 | 4.32 |
| | 1100 | 0.02 | 0.01 | 0.02 | 0.30 | 3.43 |
| | 1200 | 0.01 | 0.01 | 0.00 | 0.25 | 2.81 |

The film thickness (d2) of the second conductive layer 13 can be appropriately arranged depending on the film thickness (total film thickness) of the back electrode layer 11 and the film thickness (dl) of the first conductive layer 12.
The second conductive layer 13 is formed on a substantially entire area of the second main surface side of the first conductive layer 12.

Herein, the phrase "formed on a substantially entire area", as described above, denotes that 90 percent or more of the reference surface is covered.

Specifically, the phrase "the second conductive layer 13 is formed on a substantially entire area of the second main surface side of the first conductive layer 12" denotes that 90 percent or more of the surface of the second main surface side of the first conductive layer 12 is covered with the second conductive layer 13.

The second conductive layer 13 can be formed of a material such as a thin film made from a conductive material having high density or paste.

In order to sufficiently reduce a series resistance, the second conductive layer 13 is preferably formed on the entire area.

In this case, it is more preferable that the first conductive layer 12 is formed on the entire area. In sum, both the first conductive layer 12 and the second conductive layer 13 are preferably formed on the entire area of the surface of the second main surface side. In other words, it is preferable that the first conductive layer 12 is formed on the entire area of the surface of the second main surface side of the second transparent electrode layer 10, while the second conductive layer 13 is formed on the entire area of the surface of the second main surface side of the first conductive layer 12.

Herein, in order to reduce a resistance and limit an increase in cost of materials, it is more preferable to form a thin film made from a conductive material having high density on the entire area.

Comparing the crystalline silicon solar cell 1 in this embodiment with a thin film silicon solar cell, since the latter is designed to generally have unit cells, each having a small area by integration or the like so as to reduce a power generation current density, the thin film silicon solar cell normally employs a back electrode in which a film having a thickness of about 100 to 300 nm is formed on an entire area. At this time, it is necessary to select a material to be used in order to increase a reflectance and reduce a series resistance. Since the film thickness of the back electrode (back electrode layer) is thin, silver is used, though it is generally high cost.

In contrast, the crystalline silicon solar cell 1 in this embodiment generally uses the back electrode layer 11 having a film thickness of about 250 nm or more because of the necessity of thickening the film thickness to some extent. This is because a size of the silicon substrate 2 (crystalline silicon substrate) used for the crystalline silicon solar cell 1 (also referred to as a cell) is normally 5 to 6 inch squares, resulting in an enlarged power generation current density of about 5A to 9A per cell.

Hence, in order to further reduce a loss by a series resistance, the film thickness of the back electrode layer 11 formed on the entire area of the back surface of the crystalline silicon solar cell 1 is generally thicker than that of a thin film silicon solar cell.

Consequently, the crystalline silicon solar cell 1 in this embodiment needs a larger amount of a metal material used for the back electrode layer 11 than that of a thin film silicon solar cell.

Hence, in view of lowering costs, the back electrode layer 11 is partly or wholly formed of copper having the same electrical conductivity as silver and being low in cost. Even when the film thickness is thick, the back electrode layer 11 is formed at lower cost than the use of silver alone. However, as described above, as copper has a very fast diffusion velocity to crystalline silicon, the use of copper for the back electrode layer 11 instead of silver causes copper diffusion, resulting in reduced solar cell characteristics. Besides having a lower reflectance on the longer wavelength side than that of silver, copper has problems such as a reduced light reflecting amount and a reduced electric current.

Thus, in the crystalline silicon solar cell 1 in this embodiment, as described above, the back electrode layer 11 is formed by the predetermined first conductive layer 12 and the second conductive layer 13 containing copper as a major ingredient stacked in this order from the second transparent electrode layer 10 side. Such a back electrode layer 11 is used and the second transparent electrode layer 10 and the first conductive layer 12 described above are made within a predetermined range in thickness.

By these arrangements, even with the use of the second conductive layer 13 containing copper as a main ingredient, the second transparent electrode layer 10 and the first conductive layer 12 suppress the diffusion of copper into the silicon substrate 2 (crystalline silicon substrate) while the same reflectance as that in the case of silver is maintained. Further, the crystalline silicon solar cell 1 is produced at a lower cost than conventional ones.

In sum, as described above, this embodiment uses the second conductive layer 13 containing copper, which is low in cost, as a major ingredient, and among them, it is preferable to use copper for the second conductive layer 13 in view of lowering costs.

The thickness of the back electrode layer 11 (total thickness of the first conductive layer 12 and the second conductive layer 13) based on the above description is preferably 250 nm or more, more preferably 300 nm or more, and most preferably 500 nm or more. Further, the thickness of the back electrode layer 11 is preferably 800 nm or less, more preferably 700 nm or less, and most preferably 600 nm or less.

Several methods may be applicable to produce the first conductive layer 12 and the production method includes a physical vapor-phase deposition method such as a sputtering method or a vacuum evaporation method, a screen printing method, or a plating method. The sputtering method, the vacuum evaporation method, or the like is preferably used.

By such a method, the first conductive layer 12 made from a conductive material having high density is formed on the substantially entire area of the second main surface side.

Among them, a material such as silver or gold is used for the first conductive layer 12, the sputtering method is preferably used in view of reducing production costs and ensuring good coverage. Even when the film thickness is thin, that sufficiently covers the surface (the film is formed on the substantially entire area with high accuracy) and gives sufficiently high back surface light reflection characteristics and copper diffusion prevention characteristics.

Several methods may be applicable to produce the second conductive layer 13, and the production method is not particularly limited and includes a physical vapor-phase deposition method, such as a sputtering method or a vacuum evaporation method, a screen printing method, or a plating method. Especially, in this embodiment, the sputtering method is preferably used because the layer 13 is formed on the substantially entire area of the first conductive layer 12.

When the first conductive layer 12 and the second conductive layer 13 are formed by a sputtering method, continuous film-formation of the back electrode layer 11 by the same device is enabled. Further, other effects, such as an antioxidation of the back electrode layer 11 and an improved adhesion degree on a film interface (interface between the second transparent electrode layer 10 and the back electrode layer 11) can be expected. Still further, a sputtering method is preferably used in view of productivity. It is more preferable to form both the first conductive layer 12 and the second conductive layer 13 by a sputtering method.

The second conductive layer 13 is expected to obtain a certain level of thickness, so that a plating method is one of the effective methods in view of lowering costs.

As described above, since the transparent electrode layers 6 and 10 in this embodiment are formed by a sputtering method, so that the back electrode layer 11 is preferably formed continuously after the formation of the transparent electrode layers 6 and 10.

Especially, it is preferable to form the second transparent electrode layer 10 and the back electrode layer 11 located on the back surface side in this order after the formation of the first transparent electrode layer 6 on the light-incident surface side.

In order to prevent an electrical short circuit at the peripheral part of the silicon substrate 2, the present embodiment performs, as described below, an insulating step after the formation of the first main surface-side electrode layer 25, the second main surface-side electrode layer 26, and the photoelectric conversion section 27.

The back electrode layer 11 may include other conductive layers than the first conductive layer 12 and the second conductive layer 13, unless it ruins the function of this embodiment (function of preventing the diffusion of copper to the silicon substrate 2, for example). Among them, it is more preferable to form a conductive layer (protection layer) on the back electrode layer 11 so as to cover the surface of the back electrode layer 11 (surface of the back electrode layer 11 on an opposite side to the second transparent electrode layer 10).

By the formation of the protection layer, a deterioration of the back electrode layer 11 is reduced even when the below-mentioned heat treatment step is performed.

The protection layer may be formed of either a conductive material or an insulative material. The use of the conductive material reduces the resistance of the collector electrodes 15, thereby more reducing the resistance loss of the collector electrodes 15, which may improve the fill factor (FF).

The conductive material applicable to the protection layer preferably has a diffusion velocity in the silicon substrate 2 slower than that in the back electrode layer 11 in view of suppressing the diffusion in the back electrode layer 11. Such a material includes titanium (Ti), chromium (Cr), nickel (Ni), tin (Sn) and silver (Ag). Among them, in view of suppressing sulfurization and oxidation of the second conductive layer 13 of the back electrode layer 11, Ti, Sn, or Ni is more preferable.

As to the upper limit, the protection layer is preferably a dense film in view of suppressing diffusion in the back electrode layer 11.

The film thickness is not particularly limited, but is preferably 500 nm or less and more preferably 100 nm or less.

Additionally, the film thickness is preferably 5 nm or more and more preferably 10 nm or more in view of further suppressing the diffusion in the back electrode layer 11. The protection layer is preferably formed by a method such as a sputtering method or a plating method in view of forming a dense film.

As described above, the collector electrodes 15 are formed on the light-incident side of the first transparent electrode layer 6.

The collector electrodes 15 each can be produced by a known method such as an ink jet method, a screen printing method, a wire adhesion method, a spraying method, a vacuum evaporation method, or a sputtering method, and is preferably produced by a method such as a screen printing method using Ag paste or a plating method using copper in view of productivity.

Now, an outer shape of the crystalline silicon solar cell 1 will be described in detail below.

The crystalline silicon solar cell 1 is, as shown in Fig. 2, in the form of a plate having a substantially square shape from a plane view.

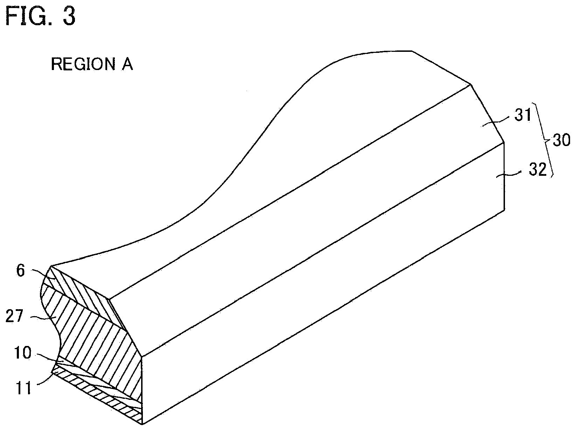

The crystalline silicon solar cell 1 has an insulating region 30, as shown in Fig. 3, near an end portion in an in-plane direction.

The insulating region 30 is a region where a short circuit, which might be caused between at least the first transparent electrode layer 6 located on the first main surface side and at least the second transparent electrode layer 10 and the back electrode layer 11 located on the second main surface side when the crystalline silicon solar cell 1 is operated, is removed.

Specifically, the insulating region 30 is a region which has undergone the removal of a component constituting at least the first transparent electrode layer 6 on the first main surface side of the silicon substrate 2 and/or at least the second transparent electrode layer 10 and the back electrode layer 11 on the second main surface side thereof, resulting in a region without adhesion of the component.

Herein "the region without adhesion of the component" is not limited to a region where material elements constituting the relevant layer are not detected at all, and includes a region in which the adhesion of the surrounding "formed parts" to the material elements is comparatively much lower, and where the characteristics (electrical characteristics, optical characteristics, mechanical characteristics, and so on) of the relevant layer are not expressed. In other words, it includes a region that does not function as a layer due to an excessively low adhesion to the materials.

Since the crystalline silicon solar cell 1 in this embodiment is a hetero-junction solar cell, the insulating region 30 is preferably formed so that the opposite conductivity-type silicon thin film layer 5 on the first main surface side and the one conductivity-type silicon thin film layer 8 on the second main surface side do not adhere thereto, in addition to at least the first transparent electrode layer 6 on the first main surface side and at least the second transparent electrode layer 10 and the back electrode layer 11 on the second main surface side not adhering thereto, and is most preferably formed so that the one conductivity-type single crystalline silicon substrate 2 is exposed. In this way, the formation further improves a short circuit prevention effect.

The insulating region 30 is, as shown in Fig. 3, constituted by a second region 32 and a first region 31 (inclined region) in order from an end side (end face side).

The first region 31 is a wall surface forming part where a wall surface is formed by a laser beam. The first region 31 extends in a direction slightly inclined relative to a direction perpendicular to the first main surface. In other words, the first region 31 inclines downward and outward from the first main surface toward the second main surface.

The first region 31 has a relatively smooth surface and has a trace of laser formed by being melted by a laser beam.

The second region 32 (side face) is an end face forming part where an end face of the crystalline silicon solar cell 1 is formed. In other words, the second region 32 is a part forming an outer side face of the crystalline silicon solar cell 1.

The second region 32 extends in a direction substantially perpendicular to the second main surface and reaches at least the first conductive layer 12 from the second main surface (second main surface side of the crystalline silicon solar cell 1). In sum, the second region 32 may reach the first conductive layer 12 from the second main surface side of the crystalline silicon solar cell 1, and may also reach the second transparent electrode layer 10, for example.

Further, surface roughness (arithmetic average surface roughness) of the second region 32 is different from that of the first region 31.

As described above, the first region 31 on the first main surface side forms an inclined surface, while the second region 32 is continuous to the first region 31 and reaches the second main surface, which extends in a substantially vertical direction. Therefore, in the crystalline silicon solar cell 1, the first main surface has an area smaller than that of the second main surface.

Now, a method for producing the crystalline silicon solar cell 1 will be described in detail below.

The crystalline silicon solar cell 1 is produced by forming a film by a film-forming device such as a plasma CVD device or a sputter device not shown and shape-processing by a device such as a laser scribing device (not shown).

Firstly, a photoelectric conversion section forming step of forming the photoelectric conversion section 27 of the crystalline silicon solar cell 1 is performed.

In advance, the step processes the silicon substrate 2 so as to form a texture structure (texture forming step).
Thereby, concavities and convexes have been formed on the front and the back surfaces of the silicon substrate 2.

After that, the silicon substrate 2 having the texture structure is placed in a film-forming device such as a plasma CVD device. Specifically, the silicon substrate 2 is set on a substrate stage of the film-forming device so that a surface (main surface of the light-incident side) on the first main surface side of the silicon substrate 2 is exposed (first main surface setting step).

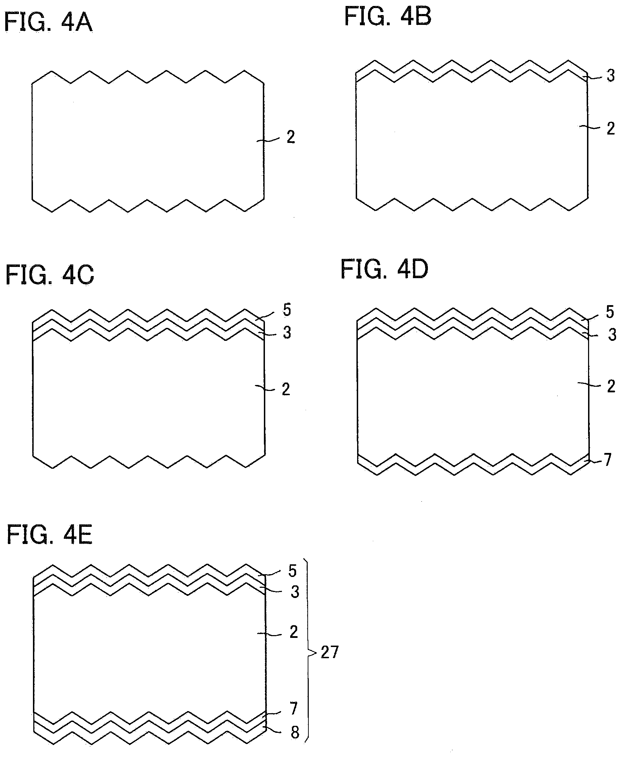

Then, as shown in Figs. 4A, 4B, and 4C, the silicon thin film layers 3 and 5 are formed on the first main surface of the silicon substrate 2 having been set on the substrate stage (front surface-side silicon thin film layer forming step).

More specifically, in the front surface-side silicon thin film layer forming step, after the first intrinsic silicon thin film layer 3 has been formed (first intrinsic silicon thin film layer forming step) as shown in Fig. 4B, the opposite conductivity-type silicon thin film layer 5 is formed (first silicon thin film layer forming step) as shown in Fig. 4C.

At this time, the silicon thin film layers 3 and 5 are preferably formed under the conditions of a substrate temperature at 100 to 300 degrees centigrade, a pressure at 20 to 2600 Pa, and a high-frequency power density at 0.004 to 0.8 W/cm².

The silicon thin film layers 3 and 5 are formed using a gas containing silicon such as SiH₄ or Si₂H₆ or a mixture gas including a silicon containing gas and H₂ (hydrogen gas) as a material gas.

As a separate step, the silicon substrate 2 is set on the substrate stage of the film forming device so that a surface (main surface of the back surface side) on the second main surface side of the silicon substrate 2 is exposed (second main surface setting step). Then, as shown in Figs. 4D and 4E, the silicon thin film layers 7 and 8 are formed or deposited on the surface of the second main surface side of the silicon substrate 2 having been set on the substrate stage (back surface-side silicon thin film layer forming step).

More specifically, in the back surface-side silicon thin film layer forming step, after the second intrinsic silicon thin film layer 7 has been formed (second intrinsic silicon thin film layer forming step) as shown in Fig. 4D, the one conductivity-type silicon thin film layer 8 is formed (second silicon thin film layer forming step) as shown in Fig. 4E.

At this time, the silicon thin film layers 7 and 8 are preferably formed under the conditions of a substrate temperature at 100 to 300 degrees centigrade, a pressure at 20 to 2600 Pa, and a high-frequency power density at 0.004 to 0.8 W/cm². The silicon thin film layers 7 and 8 are formed using a gas containing silicon such as SiH₄ or Si₂H₆ or a mixture gas including a silicon containing gas and H₂ (hydrogen gas) as a material gas.

When the photoelectric conversion section 27 has been formed after completing the front surface-side silicon thin film layer forming step and the back surface-side silicon thin film layer forming step, the firm-formed substrate is set to the sputtering device and undergoes a transparent electrode layer forming step.

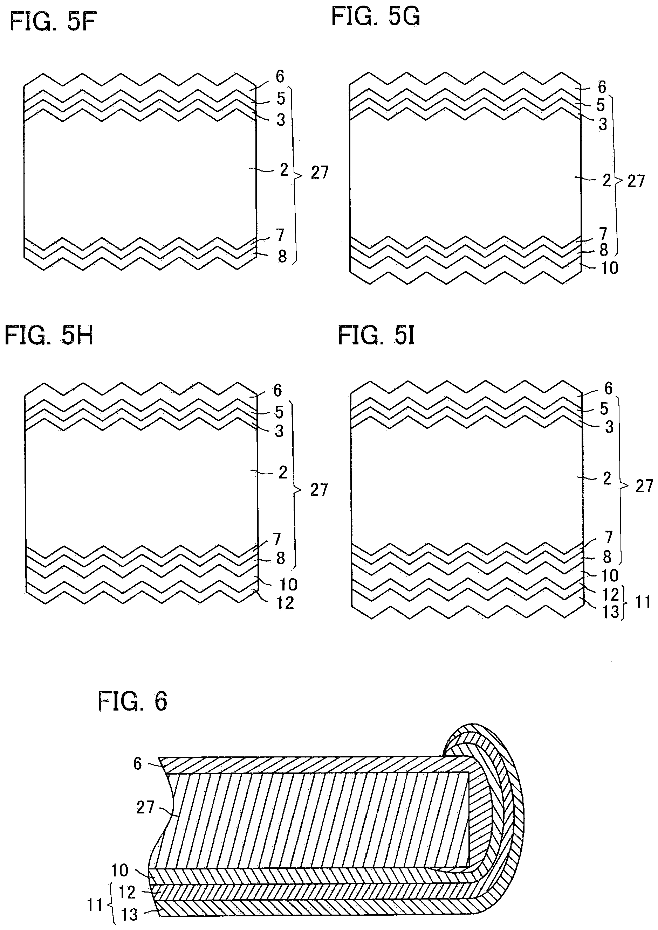

Specifically, the first transparent electrode layer 6 is formed on the opposite conductivity-type silicon thin film layer 5 of the light-incident surface side (first transparent electrode layer forming step) as shown in Fig. 5F, and then, the second transparent electrode layer 10 is formed on the one conductivity-type silicon thin film layer 8 of the back surface-side (second transparent electrode layer forming step) as shown in Fig. 5G.

At this time, an area to form a film by the sputtering device is set as large as or slightly larger than the area of the substrate.

After the transparent electrode layer forming steps, the back electrode layer 11 containing Cu as a major ingredient is successively formed on the substantially entire area of the second transparent electrode layer 10 of the surface of the second main surface side (back electrode layer forming step).

Specifically, the first conductive layer 12 is formed on the substantially entire area of the second transparent electrode layer 10 of the surface of the second main surface side (first conductive layer forming step) as shown in Fig. 5H. Then, as shown in Fig. 5I, the second conductive layer 13 is successively formed on the first conductive layer 12 (second conductive layer forming step). In this way, the back electrode layer 11, constituted by the first conductive layer 12 and the second conductive layer 13, is formed on the second transparent electrode layer 10.

Herein, "the substantially entire area of the second transparent electrode layer 10" denotes that the back electrode layer 11 is formed on the entire surface of the second transparent electrode layer 10.

Especially, in view of sheet resistance reduction, the layer 11 is formed on more preferably 95 percent or more of the surface of the second transparent electrode layer 10, and most preferably 100 percent of, or the entire area of the second transparent electrode layer 10.

To put this in perspective, only the second transparent electrode layer 10 is formed in a region where the back electrode layer 11 is not formed, i.e., a copper non-formed region, so that a sheet resistance in this region is normally higher than that in a copper formed region (region where the back electrode layer 11 is formed).

Consequently, when the back electrode layer 11 is formed on the entire area, an improved fill factor due to a reduced sheet resistance can be expected.

When the crystalline silicon solar cell 1 in this embodiment is produced, as described above, the first transparent electrode layer 6 on the light-incident surface side is formed, followed by the formation of the second transparent electrode layer 10 on the back surface side.
Then, in a case where the film-formed area of the first transparent electrode layer 6 or that of the second transparent electrode layer 10 is larger than the area of the silicon substrate 2 as in the present embodiment, the silicon thin film layers 5 and 8 and/or the transparent electrode layers 6 and 10 on the front surface (light-incident surface) and/or the back surface extends around to the surfaces other than the relevant surfaces, as shown in Fig. 6.

In this embodiment, the first transparent electrode layer 6 is formed astride the second main surface side from the first main surface side, as shown in Fig. 6. The second transparent electrode layer 10 is formed astride the first main surface side from the second main surface side. In sum, on the first main surface side and the second main surface side, there are regions where the first transparent electrode layer 6 and the second transparent electrode layer 10 are superposed.
In this way, the insulating step should be performed so as to prevent a future electrical short circuit predicted to occur by extension of the silicon thin film layers 5 and 8 and/or the transparent electrode layers 6 and 10 on the front surface (light-incident surface) and/or the back surface to the surfaces other than the relevant surfaces.

Specifically, in line with the present embodiment, since the first transparent electrode layer 6 on the light-incident surface side extends around to the one conductivity-type silicon thin film layer 8 on the back surface side and/or the second transparent electrode layer 10 on the back surface side extends around to the first transparent electrode layer 6 on the light-incident surface side as shown in Fig. 6, it is necessary to essentially insulate an electrical connection between the transparent electrode layers 6 and 10.

Hence, in the method of producing the crystalline silicon solar cell 1 of the present invention, the insulating step is performed after the back electrode layer 11 has been formed. In sum, the insulating step is performed after the back electrode layer forming step.

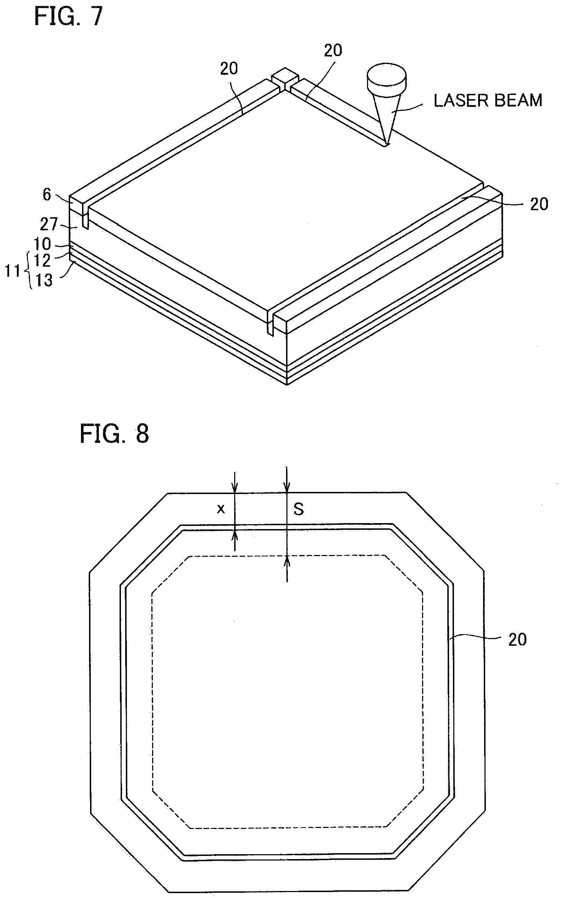

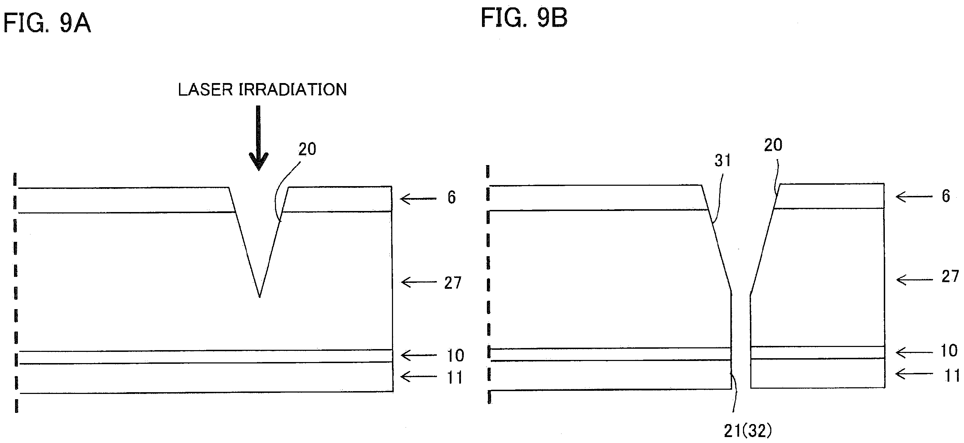

Specifically, a laser beam is irradiated to the substrate on which the back electrode layer 11 has been formed from the first main surface side onto a position located in a predetermined range from an outer peripheral end face of the one conductivity-type single crystalline silicon substrate 2 along an entire periphery of the outer peripheral part of the first main surface. In short, as shown in Figs. 7, 9A, and 9B, the laser beam is irradiated from the first main surface side (first transparent electrode layer 6 side), thereby forming a cleaving groove 20 along the entire periphery of the outer peripheral part of the first main surface (laser irradiation step).

At this time, as shown in Fig. 8, the cleaving groove 20 is formed at a distance S (in a range within 3 mm) away from the outer peripheral end face of the silicon substrate 2 (end face of the silicon substrate 2) in a plane view of the silicon substrate 2 and annularly along the outer peripheral part of the silicon substrate 2.
Specifically, as indicated with hatched lines in Fig. 2, the cleaving groove 20 is formed along the entire periphery near the end face of the silicon substrate 2 so as not to cover the side face of the silicon substrate 2.

In other words, the cleaving groove 20 is located inside with respect to the side face of the silicon substrate 2, and thus, the silicon substrate 2 and the other layers lie outside the cleaving groove 20.

At this time, the cleaving groove 20 has a depth penetrating through at least the first transparent electrode layer 6 and the first intrinsic silicon thin film layer 3 to reach a part or the whole of the silicon substrate 2. In order to facilitate the below-mentioned cleaving step, the depth of the cleaving groove 20 is one quarter or more of the thickness of the silicon substrate 2, more preferably one third or more of that, and further more preferably one half or more of that.
Within the above-mentioned range, it is possible to reduce a force added to the silicon substrate 2 in the cleaving step.

As to a position to be irradiated by the laser beam, as shown in Fig. 8, when a distance from the end part of the silicon substrate 2 is set as X, X satisfies preferably 0 < X < 3 mm, more preferably 0 < X < 2 mm, further more preferably 0 < X < 1 mm, and most preferably 0 < X < 0.5 mm.

The laser beam has a beam shape not particularly limited and may be, for example, a so called Gaussian beam or Top-Hat beam.
In this embodiment, the laser beam uses a Gaussian beam.

Herein, an advantageous effect of the irradiation of the laser beam from the light-incident surface side will be described below.
As described above, in this embodiment, the second conductive layer 13 containing copper (Cu) as a major ingredient is formed on the substantially entire area of the outermost surface of the back electrode layer 11.

Thus, when the laser beam is irradiated from the back surface side, as shown in Fig. 17, the laser beam blows out melted or evaporated copper (Cu), which may stick to an edge of the crystalline silicon solar cell 1 having been processed (hatched line portion in Fig. 17). Cu would diffuse into the silicon substrate 2 from the edge as time passes. Specifically, the melted or evaporated copper (Cu) might stick to the inner wall surfaces of the cleaving groove 20 formed by the laser beam and diffuse into the silicon substrate 2 from the inner wall surfaces with the passage of time or the generation of power.

In this way, when copper (Cu) constituting the second conductive layer forming the outermost surface of the back electrode layer 11 diffuses into the silicon substrate 2 by the laser beam, copper functions as a recombination center, particularly resulting in the reduction of an open-circuit voltage or a short circuit current.
That can be also generally said in a case where any metal is used for the back electrode layer 11, so that diffusion can occur in a case of silver (Ag) or aluminum (Al) generally used for the back electrode layer.

However, copper (Cu) remarkably has a very fast diffusion velocity compared to silicon.
Consequently, if copper (Cu) of the second conductive layer 13 located on the outermost surface of the back electrode layer 11 diffuses to the silicon substrate 2, solar cell characteristics are considered to be deteriorated.

In contrast, when the laser beam is irradiated from the light-incident surface side of the crystalline silicon solar cell 1 as in this embodiment, as shown in Fig. 9A, the laser beam does not reach the back electrode layer 11 at all, and even if it is reached, copper (Cu) blown out by the laser beam is hardly stuck to the end part (inner wall surfaces of the cleaving groove 20) of the crystalline silicon solar cell 1 located nearer to the laser irradiation side (light-incident side) than the back electrode layer 11. Thus, it is possible to prevent the diffusion of copper from the end part (inner wall surfaces of the cleaving groove 20) into the silicon substrate 2.

Further, the irradiation of the laser beam from the light-incident surface side of the crystalline silicon solar cell 1 allows laser processing of parts symmetric to the collector electrodes 15 of the light-receiving surface side. This arranges the collector electrodes 15 at roughly uniform distances from the end part, compared to a case of laser irradiation from the back surface side. This minimizes an electrical resistance loss due to a positional displacement of the collector electrodes 15 and stably keeps the fill factor at a high value in mass production.
In view of the facts described above, in the present embodiment, the laser beam is irradiated from the light-incident surface side.

The cleaving groove 20 formed in the laser irradiation step, as shown in Fig. 9A, is a bottomed groove with a groove width gradually narrowing as it advances to its depth direction (from the first main surface side toward the second main surface side). In other words, as the groove 20 advances to its depth direction (from the first main surface side toward the second main surface side), a distance between the inner wall surfaces becomes short. In sum, the cleaving groove 20 has a tapered cross section.

Getting back to the description of the production method, the substrate on which the cleaving groove 20 has been formed in the laser irradiation step is, as shown in Fig. 9B, bent and cleaved by a force added along the cleaving groove 20 (cleaving step).

At this time, the cleaving groove 20 is cleaved so that the groove width is widened, thereby forming a surface (cleaved surface 21) extending in a different direction from the inner wall surfaces of the cleaving groove 20, the surface of which becomes a part of an insulating region 30 forming the end face of the crystalline silicon solar cell 1. The cleaved surface 21 inclines at an inclined angle different from that of the inner wall surfaces of the cleaving groove 20, and at a largely inclined angle relative to a horizontal plane when the substrate is placed on the horizontal plane. Specifically, the cleaved surface 21 extends in a direction substantially perpendicular to the horizontal plane.
At this time, one of the inner wall surfaces of the cleaving groove 20 forms a first region 31, while the cleaved surface 21 forms a second region 32.
At this time, a means of adding a force to cleave the substrate is not particularly limited. The external force may be added by human power or by a machine so as to cleave it. In a case of a machine, the machine may be used manually or automatically.

After the formation of the insulating region 30 (after the insulating step), a heat treatment is performed (heat treatment step).
Specifically, the substrate having undergone the cleaving is placed into a heat treatment device and heated at a predetermined temperature so as to be annealed.

At this time, the insulating region 30 is heated at a heating temperature (annealing temperature) preferably 150 degrees centigrade or more and more preferably 170 degrees centigrade or more in view of suppressing a leakage of current.

Meanwhile, since the crystalline silicon solar cell 1 includes the conductivity-type silicon thin film layers 5 and 8 and the transparent electrode layers 6 and 10, the crystalline silicon solar cell 1 is heated at a heating temperature preferably 250 degrees centigrade or less and more preferably 230 degrees centigrade or less in view of further suppressing the reduction of fill factor (FF) and open voltage (Voc) caused by the deterioration of these layers.

The heat treatment step may be performed under any atmosphere and at any treatment pressure, such as atmospheric pressure, reduced pressure atmosphere, vacuum, or a pressurized atmosphere.

In a case where the protection layer is not formed on the back electrode layer 11 as described above, the step is preferably performed under a reduced atmosphere, in a vacuum, or under an atmosphere in which an oxidizing gas is reduced in view of further suppressing the deterioration (oxidation, for example) of the back electrode layer 11.

The term "in the air" denotes that the heat treatment step is performed under an atmosphere without particularly controlling a composition or pressure of the air atmosphere. Herein, when the heat treatment step is performed in an airtight facility, an atmosphere sealed in the facility expands with heat by heating, possibly rendering the pressure in the facility higher than the atmospheric pressure. However, such a case is also regarded as "under atmospheric pressure."

Further, as described above, when the collector electrode 15 of the light-incident surface side is formed of a material such as a conductive paste containing resin paste, the paste is generally hardened at about 170 to 210 degrees centigrade separately after having been dried at 150 degrees centigrade. At this time, the hardening of the collector electrode 15 is preferably performed in the above-mentioned heat treatment step.

Herein, the collector electrode 15 may be formed before the insulating step or after the insulating step.

However, it is preferable to perform the insulating step before forming the collector electrode 15.

In this way, the heat treatment step suppresses a leakage of current in the insulating region 30.

It is possible, for example, to further suppress damage to a p-n junction part extending from the one conductivity-type single crystalline silicon substrate 2 to the opposite conductivity-type silicon thin film layer 5, the damage being possibly caused when the groove is formed on the p-n junction part by laser irradiation from the first main surface side.

The method for producing the crystalline silicon solar cell 1 in this embodiment is performed through the above-mentioned main steps.

The above explanation describes the crystalline silicon solar cell 1 by a single body, but a plurality of crystalline silicon solar cells 1 are modulated by appropriately combining them for permitting a practical use.

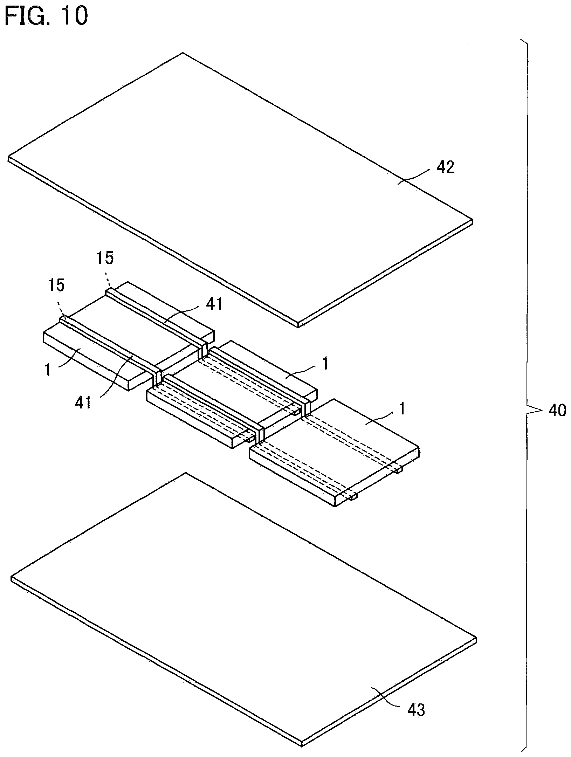

Hence, a method for producing solar cell module 40 using the crystalline silicon solar cell 1 in this embodiment will be described in detail below, making reference to Fig. 10.

First, wiring members 41 are connected to the collector electrodes 15 of the crystalline silicon solar cell 1 formed by the above-mentioned production method. Other parts of the wiring members 41 are connected to the other crystalline silicon solar cells (including the crystalline silicon solar cell 1 in this embodiment). This electrically connects a plurality of crystalline silicon solar cells in series or in parallel.
Herein, the wiring members are each a known interconnector such as a tab.

Then, the crystalline silicon solar cells are sandwiched between a glass substrate 42 and a back sheet 43. A gap between the glass substrate 42 (first sealing member) and the back sheet 43 (second sealing member) is filled with a material such as a liquid or solid sealant (not shown), so as to be sealed.

As described above, a plurality of crystalline silicon solar cells are sealed, thereby forming the solar cell module 40 in the present embodiment.

Like conventional ones, in a case where the back electrode layer 11 is formed of copper, which has an extremely fast diffusion velocity, on the second transparent electrode layer 10, it is preferable to thicken the film thickness of the second transparent electrode layer 10 (about 100 nm, for example) in view of preventing diffusion.

However, the thicker the film thickness is, the more the transparent electrode layer absorbs light, which may cause a problem of a reduced short circuit current density (Jsc). Hence, as described above, the film thickness is preferably 180 nm or less.

According to the crystalline silicon solar cell 1 in this embodiment, as described above, the predetermined first conductive layer 12 is formed between the second transparent electrode layer 10 and the second conductive layer 13 (second electrode layer) containing copper as a major ingredient, thereby suppressing copper diffusion. Therefore, even when the film thickness of the second transparent electrode layer 10 is thin as within the above-mentioned range, the diffusion of copper constituting the second conductive layer 13 (second electrode layer) is suppressed.

The method for producing the crystalline silicon solar cell 1 in this embodiment forms the insulating region 30, in which a short circuit occurring between at least the first transparent electrode layer 6 on the first main surface side and at least the second transparent electrode layer 10 and the back electrode layer 11 on the second main surface side, is removed in the insulating step. That solves a problem of a short circuit occurring between the first transparent electrode layer 6 on the light-incident surface side and the second transparent electrode layer 10 and the back electrode layer 11 on the back surface side due to the extension of the electrode layers 6, 10, and 11.

As described above, the method for producing the crystalline silicon solar cell 1 in this embodiment produces a crystalline silicon solar cell with a high efficiency and high reliability. Further, a crystalline silicon solar cell with an excellent productivity at low cost is produced.

Now, a crystalline silicon solar cell 50 in a second embodiment will be described below. Herein, the same numerals are assigned to the same members as those in the first embodiment and their descriptions are omitted.

The crystalline silicon solar cell 50 in the second embodiment is produced by a different method from that of the crystalline silicon solar cell 1 in the first embodiment. Specifically, the crystalline silicon solar cell 50 in the second embodiment has a different insulating step from that of the crystalline silicon solar cell 1 in the first embodiment and performs an insulation treatment only by a laser beam irradiation step.

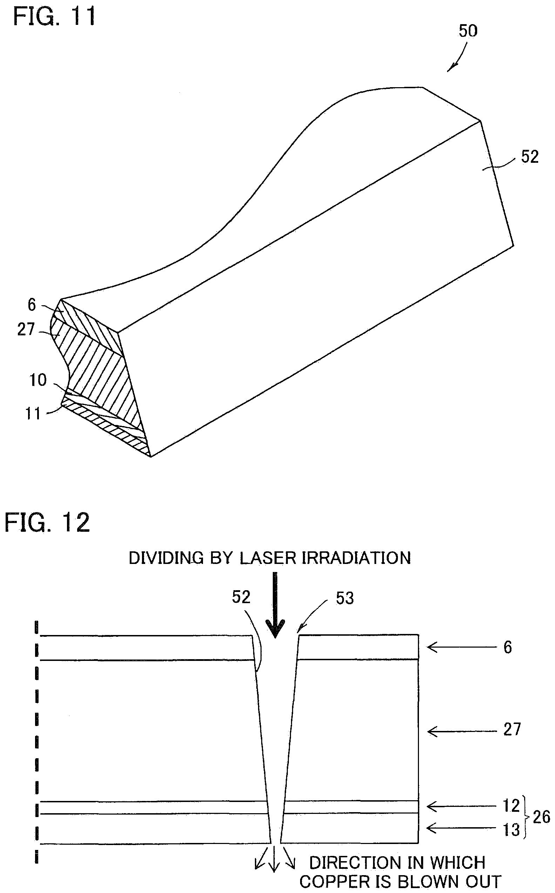

The crystalline silicon solar cell 50 has an insulating region 51 consisting of a first region 52 (inclined region), as shown in Fig. 11.
The first region 52 is formed by a laser beam as well as the first region 31 in the first embodiment. The first region 52 has a surface formed by a trace of laser and extends in a direction slightly inclined to a direction perpendicular to a first main surface. In other words, the region 52 inclines downward and outward from the first main surface toward a second main surface. Thus, the first main surface of the crystalline silicon solar cell 50 has an area smaller than that of the second main surface.

Herein, the term "incline or inclined" denotes "incline or inclined as a whole surface." Hence, the inclined surface needs not necessarily be a smooth surface and may have slight irregularities.

In this embodiment, in the first region, it is only necessarily to have a positional shifting in a surface direction between an end part of the first main surface side and an end part of the second main surface.

Next, a method for producing the crystalline silicon solar cell 50 will be described in detail below.

The method for producing the crystalline silicon solar cell 50 in the second embodiment is different in the insulating step from that of the method for producing the crystalline silicon solar cell 1 in the first embodiment.

Specifically, in the insulating step in the second embodiment, as shown in Fig. 12, the laser beam is irradiated from the first main surface side so as to penetrate through the silicon substrate 2 in a thickness direction up to the back electrode layer 11. In other words, a portion removed by the laser beam is different from that in the laser irradiation step in the first embodiment, so that the laser irradiation step completely divides into a plurality of regions.

In sum, the laser beam is irradiated from the first main surface side to reach the second main surface side in the insulating step (laser irradiation step).

A groove 53 formed at this time is a through hole, whose inner side face forms the first region 52. In other words, the trace of laser reaching the second main surface from the first main surface is formed on the substrate on which the laser beam has been irradiated.

Herein, other conditions such as a position where the groove 53 is formed are the same as those of the cleaving groove 20 in the first embodiment.

The method for producing the crystalline silicon solar cell 50 in the second embodiment removes an unnecessary part of the substrate in the laser irradiation step in the insulating step, thereby eliminating a cleaving step. This simplifies the steps.

The method for producing the crystalline silicon solar cell 50 in the second embodiment dispenses with a separate cleaving step, so that the laser beam is irradiated to a region closer to an end part of the crystalline silicon solar cell 50.

The above-mentioned embodiments explain an example of methods for forming the solar cell module 40 using the crystalline silicon solar cell 1, but a plurality of crystalline silicon solar cells 1 are appropriately combined by another method, thereby being modulated by an appropriate method for permitting a practical use.

A plurality of crystalline silicon solar cells 1 are connected in series or in parallel by connecting a bus bar to the collector electrodes 15 via an interconnector such as a tab and modulated by sealing by a sealant and a glass board, for example.

The above-mentioned embodiments employ a back electrode layer 11 having a multilayer structure constituted by the first conductive layer and the second conductive layer, but the present invention is not limited thereto and may employ a back electrode layer 11 having a single layer structure.

When being a single layer, for example, the back electrode layer 11 may be constituted only by the second conductive layer 13 containing copper as a major ingredient. In this case, diffusion is prevented by adjusting a film thickness of a layer such as the second transparent electrode layer 10. When being a multilayer, the back electrode layer 11 may be formed by laminating the second conductive layer 13 and another layer (layer other than the second conductive layer 13) in this order from the second transparent electrode layer 10 side.
The method of forming the back electrode layer 11 of a single layer includes, for example, a sputtering method, an evaporation method, and a plating method. Among them, the sputtering method is preferably used in view of easily forming the layer 11 on the entire area of the back surface side.

It is preferable to form the back electrode layer 11 by the sputtering method since the substrate is covered with high accuracy.

Especially, in the use of a substrate with a convex/concave structure as the silicon substrate 2, it is more preferable to form the layer 11 by the sputtering method since the convex/concave part of the substrate is covered with high accuracy.

The provision of the above-mentioned configuration improves a conversion efficiency of the solar cells.

In the above-mentioned embodiments, the forming order of the second intrinsic silicon thin film layer 7, the one conductivity-type silicon thin film layer 8, and the second transparent electrode layer 10 located on the second main surface side of the one conductivity-type single crystalline silicon substrate 2 is not particularly limited.

The first intrinsic silicon thin film layer 3 and the opposite conductivity-type silicon thin film layer 5 located on the first main surface side may be formed in this order after the second intrinsic silicon thin film layer 7 and the one conductivity-type silicon thin film layer 8 located on the second main surface side have been formed in this order, for example. Alternatively, the one conductivity-type silicon thin film layer 8 located on the second main surface side and the opposite conductivity-type silicon thin film layer 5 located on the first main surface side may be formed in this order after the first intrinsic silicon thin film layer 3 located on the first main surface side and the second intrinsic silicon thin film layer 7 located on the second main surface have been formed.

Alternatively, the second transparent electrode layer 10 may be formed after the first transparent electrode layer 6 has been formed in this order or in reversed order.
Alternatively, the second intrinsic silicon thin film layer 7, the one conductivity-type silicon thin film layer 8, and the second transparent electrode layer 10 may be formed in this order on the second main surface side after the first intrinsic silicon thin film layer 3, the opposite conductivity-type silicon thin film layer 5, and the first transparent electrode layer 6 have been formed in this order on the first main surface side, or in reversed order.

The above-mentioned embodiments perform the first main surface setting step before the second main surface setting step, but the present invention is not limited thereto. It is possible to perform the second main surface setting step, in which the substrate is set on the substrate stage so that the surface of the second main surface side of the one conductivity-type single crystalline silicon substrate 2 is exposed, the second intrinsic silicon thin film layer forming step, in which the second intrinsic silicon thin film layer is formed on the surface of the second main surface side, and the second silicon thin film layer forming step, in which the one conductivity-type silicon thin film layer is formed, in this order before the first main surface setting step, for example.

In the above-mentioned embodiments, the second transparent electrode layer 10 is formed after the first transparent electrode layer 6 has been formed, but the present invention is not limited thereto. The film-formation order of the first transparent electrode layer 6 and the second transparent electrode layer 10 is not particularly limited.

In the above-mentioned embodiments, the back electrode layer forming step is performed after the first transparent electrode layer forming step, and then, followed by the insulating step, but the present invention is not limited thereto. The first transparent electrode layer forming step may be performed after the back electrode layer forming step, and then, followed by the insulating step.

In the above-mentioned embodiments, the wiring members 41 are connected to the collector electrodes 15 of the crystalline silicon solar cell 1 and the other portions of the wiring members 41 are connected to the other crystalline silicon solar cells, but the present invention is not limited thereto. The other portions of the wiring members 41 may be connected to an external circuit.

### EXAMPLES

Now, the present invention will be described more specifically below, making reference to the examples.

Prior to the description of the examples of the present invention, we verify the effect of the film thickness of silver (first conductive layer 12) when the back electrode layer 11 has a two-layer structure containing silver (first conductive layer 12) and copper (second conductive layer 13).

### (Experimental Example 1)

An n-type single crystalline silicon substrate having an incident surface whose plane orientation is (100) and a thickness of 200 µm was used as the one conductivity-type single crystalline silicon substrate 2. The n-type single crystalline silicon substrate was immersed in 2 wt. percent of an aqueous HF solution for three minutes, so as to remove a silicon oxide film on the surface thereof, and was rinsed in ultrapure water twice.

Next, the substrate was immersed in 5/15 wt. percent of an aqueous KOH/isopropyl alcohol solution kept at 70 degrees centigrade for 15 minutes, so that the surface of the substrate was etched to have a texture structure.

Then, the substrate was rinsed twice in ultrapure water. The surface of the single crystalline silicon substrate (one conductivity-type single crystalline silicon substrate 2) was observed with an atomic force microscope (AFM made by Pacific Nanotechnology, Inc.). The etching propagated the most on the surface of the substrate, thereby forming a pyramid-shaped texture structure with a (111) plane exposed.

The single crystalline silicon substrate (silicon substrate 2), having been subjected to etching, was introduced into a CVD device, which formed an i-type amorphous silicon layer of 5 nm in thickness as a first intrinsic silicon thin film (first intrinsic silicon thin film layer 3) on the light-incident side.

As to the thickness of the thin film formed in this Experimental Example, a film forming speed was obtained by measuring a thickness of a film formed on a glass substrate under the same conditions as those in this Experimental Example with a spectroscopic ellipsometry (product name: M2000 made by J. A. Woollam Co.) and the thickness of the thin film formed in this Experimental Example was calculated by assuming that the film was formed at the same film forming speed as the above-mentioned case.

The i-type amorphous silicon layer (first intrinsic silicon thin film layer 3) was formed under the conditions of the substrate temperature at 170 degrees centigrade, the pressure at 120 Pa, the flow ratio of SiH₄/H₂ at 3/10, and the supplied power density at 0.011 W/cm².
A p-type amorphous silicon layer of 7 nm in thickness was formed on the i-type amorphous silicon layer (first intrinsic silicon thin film layer 3) as the opposite conductivity-type silicon thin film layer 5. The p-type amorphous silicon layer was formed under the conditions of the substrate temperature at 150 degrees centigrade, the pressure at 60 Pa, the flow ratio of SiH₄/B₂H₆ at 1/3, and the supplied power density at 0.01 W/cm². Herein, the above-mentioned B₂H₆ gas used a gas diluted with H₂ to have a B₂H₆ concentration of 5000 ppm.

Next, an i-type amorphous silicon layer of 6 nm in thickness was formed on the back surface side as a second intrinsic silicon thin film (second intrinsic silicon thin film layer 7). The i-type amorphous silicon layer was formed under the conditions of the substrate temperature at 150 degrees centigrade, the pressure at 120 Pa, the flow ratio of SiH₄/H₂ at 3/10, and the supplied power density at 0.011 W/cm².

An n-type amorphous silicon layer of 8 nm in thickness was formed on the i-type amorphous silicon layer (second intrinsic silicon thin film layer 7) as the one conductivity-type silicon thin film layer 8. The n-type amorphous silicon layer was formed under the conditions of the substrate temperature at 150 degrees centigrade, the pressure at 60 Pa, the flow ratio of SiH₄/PH₃ at 1/2, and the supplied power density at 0.01 W/cm². Herein, the above-mentioned PH₃ gas used a gas diluted with H₂ to have a PH₃ concentration of 5000 ppm.

The above-mentioned silicon thin films each were formed without a mask and on the entire area of the film-formed surface side of the silicon substrate 2 (side of a surface exposed to plasma).

An indium tin oxide (ITO having a refractive index of 1.9) of 70 nm in thickness was formed as a film on the resulting substrate as a light-incident side transparent electrode layer (first transparent electrode layer 6).
The film was formed using a sintered body of indium oxide and tin oxide as a target under the conditions of the substrate temperate at a room temperature, the argon atmosphere at 0.2 Pa, and the supplied power density at 0.5 W/cm².

Then, a back surface side transparent electrode layer (second transparent electrode layer 10) of 50 nm in thickness was formed under the same film-forming conditions as those of the light-incident side transparent electrode layer (first transparent electrode layer 6).
After the formation of the second transparent electrode layer 10, silver of 25 nm in thickness was formed as the first conductive layer 12 of the back electrode layer 11 by a sputtering method. Then, copper of 500 nm in thickness was formed as the second conductive layer 13 by an evaporating method.

The second transparent electrode layer 10, the first conductive layer 12, and the second conductive layer 13 each were formed without a mask and on the entire area of the silicon substrate 2.

The collector electrodes 15 were formed of silver paste on the above-mentioned light-incident side transparent electrode layer (first transparent electrode layer 6) by a screen printing method.

Thereafter, the resulting silicon substrate was placed on a laser beam machine, so that a groove is formed along the entire periphery of the outer peripheral part of the light-incident side of the crystalline silicon substrate by a laser beam.

The groove was located away from the edge of the crystalline silicon substrate by 0.5 mm. The laser beam used a third harmonic (wavelength of 355 nm) generated by a YAG laser. The groove was about one third of the thickness of the crystalline silicon substrate in depth.

And then, the substrate was bent and cleaved along the groove, whereby the outer peripheral part of the crystalline silicon substrate was removed for the insulating step. Lastly, the annealing was performed at 190 degrees centigrade for one hour.

In this way, the crystalline silicon solar cell was produced. Characteristics of the solar cell were measured by irradiating artificial solar light at the energy density of 100 W/cm² with a solar simulator having an AM 1.5 spectrum distribution at 25 degrees centigrade.

Additionally, a miniature module containing one crystalline silicon solar cell was produced and left in an environment at a temperature of 85 degrees centigrade and a humidity of 85 percent for 1000 hours for undergoing an environment test.

The miniature module had a structure constituted by the back sheet, the sealing member, the crystalline silicon solar cell to which the wiring members connected, the sealing member, and the glass. The miniature module was connected to an external measuring instrument via the wiring members attached to the crystalline silicon solar cell and underwent the measurement of characteristics of the solar cell with the above-mentioned solar simulator. Outputs of the solar cells were compared before and after the environment test and judged as a retention = (output after the environment test) / (output before the environment test) ^{∗} 100.

### (Experimental Example 2)

A crystalline silicon solar cell was produced by the same method as that in Experimental Example 1 except that silver of 50 nm in thickness was formed as the first conductive layer 12 described in Experimental Example 1, and underwent an evaluation.

### (Experimental Example 3)

A crystalline silicon solar cell was produced by the same method as that in Experimental Example 1 except that silver of 250 nm in thickness was formed as the first conductive layer 12 described in Experimental Example 1, and underwent an evaluation.

### (Experimental Example 4)

A crystalline silicon solar cell was produced by the same method as that in Experimental Example 1 except that silver of 500 nm in thickness was formed as the first conductive layer 12 described in Experimental Example 1, and underwent an evaluation.

### (Experimental Example 5)

A crystalline silicon solar cell was produced by the same method as that in Experimental Example 1 except that silver was not formed as the first conductive layer 12 described in Experimental Example 1, and underwent an evaluation.

### (Experimental Example 6)

A crystalline silicon solar cell was produced by the same method as that in Experimental Example 1 except that silver of 5 nm in thickness was formed as the first conductive layer 12 described in Experimental Example 1, and underwent an evaluation.

In the ways described above, the crystalline silicon solar cells were produced.

Table 2 shows a relationship between the short circuit current density (Jsc) and the retention when the film thicknesses of the first conductive layers were altered.

### [Table 2]

**TABLE 2**

| | FILM THICKNESS OF FIRST CONDUCTIVE LAYER (nm) | JSC (mA/cm²) | RETENTION OF PMAX (PERCENT) |
|---|---|---|---|
| EXPERIMENTAL EXAMPLE 5 | 0 | 35.2 | 93.5 |
| EXPERIMENTAL EXAMPLE 6 | 5 | 35.3 | 94.1 |
| EXPERIMENTAL EXAMPLE 1 | 25 | 35.4 | 95.2 |
| EXPERIMENTAL EXAMPLE 2 | 50 | 35.4 | 95.3 |
| EXPERIMENTAL EXAMPLE 3 | 250 | 35.4 | 95.3 |
| EXPERIMENTAL EXAMPLE 4 | 500 | 35.4 | 95.3 |

Experimental Examples 1 to 4, in each of which 25 nm or more of silver was formed as the first conductive layer 12, increased in Jsc and retention compared with Experimental Example 5 in which silver was not formed and Experimental Example 6 in which 5 nm of silver was formed. Moreover, comparing Experimental Examples 1 through 4, the formation of 25 nm or more of silver resulted in substantially saturated Jsc and retention. Especially, Experimental Examples 2, 3, and 4 reached the same degree of Jsc and retention. It is considered that this is because silver became a complete film, enough to cover the entire area of the substrate as the film thickness increased.

It is thought that the reason why Experimental Examples 1 to 4 and 6 containing silver improved in Jsc value as compared to Experimental Example 5 containing no silver (containing only copper) is because copper has lower reflectivity than silver. This can also be suggested from the result obtained by comparing Experimental Example 6 partly containing silver (in an island shape) with Experimental Examples 1 to 4 containing silver supposedly covering the substantially entire area or the entire area of the substrate.

As to the retention, comparing Experimental Example 5 containing no silver, Experimental Example 6 partly containing silver (in an island shape), and Experimental Examples 1 to 4 containing silver covering the substantially entire area of the substrate, the retention improved as the proportion of coverage increased. Comparing Experimental Example 6 to Experimental Examples 1 to 4, the retentions were substantially saturated when the film thicknesses were 25 nm or more. That suggests that silver became the substantially complete film in Experimental Example 1, thereby further suppressing the diffusion of copper formed on the film.

At this time, in each of the above-mentioned Experimental Examples, it is thought that the retention decreased because the thickness of the second transparent electrode layer 10 was made to be 50 nm, which was the optimum value as the back electrode layer when a single layer containing silver having a lower diffusion velocity than copper was used. It is considered that the diffusion of copper is prevented and the retention is increased by thickening the film thickness of the second transparent electrode layer 10 a little more, even without the first conductive layer 12 and even when copper, which has a faster diffusion velocity, is used.

According to the above results, in view of costs, the thickness of the first conductive layer 12 is preferably about 20 to 250 nm and more preferably 20 to 100 nm.

Next, a thickness of the transparent electrode layer 10 and an influence of the copper diffusion without the first conductive layer 12 will be examined below.

### (Experimental Example 7)

A crystalline silicon solar cell was produced by the same method as that in Experimental Example 1, except that the transparent electrode layer 10 of 55 nm in film thickness in a direction vertical to the inclined surface was formed without the first conductive layer 12, and underwent an evaluation.

### (Experimental Example 8)

A crystalline silicon solar cell was produced by the same method as that in Experimental Example 7, except that the transparent electrode layer 10 of 80 nm in film thickness was formed in a direction vertical to the inclined surface, and underwent an evaluation.

Table 3 shows photoelectric conversion characteristics and retentions of the characteristics after an environment test of the solar cells produced in Experimental Examples 7 and 8 described above.

### [Table 3]

**TABLE 3**

| | FILM THICKNESS IN DIRECTION VERTICAL TO INCLINED SURFACE OF TRANSPARENT ELECTRODE LAYER (nm) | RETENTION OF Pmax (%) |
|---|---|---|
| EXPERIMENTAL EXAMPLE 7 | 55 | 93.4 |
| EXPERIMENTAL EXAMPLE 8 | 80 | 95.4 |

As shown in Table 3, when the film thickness in the direction vertical to the inclined surface of the transparent electrode layer 10 was 55 nm, the retention was 93.4 percent. When that was 80 nm, the retention was 95.4 percent. According to the results, the copper diffusion was prevented even when the film thickness was about 80 nm and even when the first conductive layer 12 was not formed.

It is obviously supposed that the provision of the first conductive layer 12 further suppresses the copper diffusion.

Next, in order to examine the prevention effect of diffusion of metal especially used for the first conductive layer 12 among metals used for the back electrode (back electrode layer 11) by the back surface side transparent electrode layer (second transparent electrode layer 10), the examination was performed by setting the thickness of the first conductive layer 12 to 90 nm and altering the thickness of the back surface side transparent electrode layer (second transparent electrode layer 10).

### (Experimental Examples 9 to 16)

Crystalline silicon solar cells were produced by the same method as that in Experimental Example 1, except that the first conductive layer 12 was formed of 90 nm of silver and that the thicknesses of the transparent electrode layers 10 were altered respectively to 0 nm (Experimental Example 9), 10 nm (Experimental Example 10), 30 nm (Experimental Example 11), 50 nm (Experimental Example 12), 80 nm (Experimental Example 13) 100 nm (Experimental Example 14), 150 nm (Experimental Example 15), and 200 nm (Experimental Example 16).

Table 4 shows the characteristics of the solar cells when the film thicknesses of the ITO layers were altered.

### [Table 4]

**TABLE 4**

| | FILM THICKNESS OF TRANSPARENT ELECTRODE LAYER (nm) | JSC (mA/cm2) | VOC (V) | FF (%) | Eff (%) | RETENTION OF Pmax (%) |
|---|---|---|---|---|---|---|
| EXPERIMENTAL EXAMPLE 9 | 0 | 34.5 | 0.678 | 76.07 | 17.82 | - |
| EXPERIMENTAL EXAMPLE 10 | 10 | 35.0 | 0.720 | 75.80 | 19.10 | 95.0 |
| EXPERIMENTAL EXAMPLE 11 | 30 | 35.1 | 0.721 | 75.92 | 19.20 | 95.1 |
| EXPERIMENTAL EXAMPLE 12 | 50 | 35.4 | 0.726 | 76.29 | 19.61 | 95.3 |
| EXPERIMENTAL EXAMPLE 13 | 80 | 34.9 | 0.721 | 76.10 | 19.13 | 95.8 |
| EXPERIMENTAL EXAMPLE 14 | 100 | 34.5 | 0.720 | 75.55 | 18.74 | 96.4 |
| EXPERIMENTAL EXAMPLE 15 | 150 | 33.2 | 0.724 | 76.15 | 18.33 | 97.5 |
| EXPERIMENTAL EXAMPLE 16 | 200 | 32.7 | 0.719 | 75.57 | 17.76 | 98.1 |

Comparing Experimental Examples 9 to 16, Experimental Example 9 containing no ITO decreased in Jsc or Voc, compared with Experimental Examples 10 to 16, each containing ITO. It is thought that this was because silver used for the first conductive layer 12 diffused into the silicon substrate and became a recombination center. Comparing Experimental Examples 10 to 15, as the thickness of the ITO thickened, the retention increased. It is thought that this was because the diffusion of the first conductive layer 12 (silver) into the crystalline silicon substrate was suppressed as the thickness of the ITO thickened.

In contrast, Experimental Example 16 containing ITO having a thickness of 200 nm decreased in conversion efficiency (Eff), compared with Experimental Examples 10 to 15 containing ITOs whose thicknesses were respectively 150 nm or less. It is thought that this was because the thicker the ITO was, more light was absorbed, resulting in reduced Jsc.

Further, comparing Experimental Examples 10 to 15, as the thickness of the ITO increased from 10 to 50 nm, the conversion efficiency increased. However, as the thickness of the ITO increased from 50 to 200 nm, the conversion efficiency decreased. It is thought that this was because the ITO covered the second main surface more completely as the thickness of the ITO increased from 10 to 50 nm, thereby further preventing metal constituting the back electrode from diffusing to the crystalline silicon substrate. It is also thought that an enhanced reflection effect by total reflection born by the ITO was obtained.

On the other hand, it is thought that the ITO having a thickness larger than a certain level of thickness (about 80 nm or more) caused absorption, which decreased Jsc as the thickness increased from 80 to 200 nm. Hence, in a case of the ITO having a thickness of about 80 nm or more, it is thought that the conversion efficiency increases more due to increased Jsc by making the thickness of the ITO thinner. Consequently, the film thickness is preferably 10 to 150 nm.

Next, examples of this invention will be described in detail below.

### (Example 1)

A crystalline silicon solar cell in this Example was a hetero-junction solar cell and had a convex/concave structure on each face of an n-type crystalline silicon substrate serving as the one conductivity-type single crystalline silicon substrate 2.
The n-type crystalline silicon substrate was provided with an i-type amorphous silicon layer (first intrinsic silicon thin film layer 3), a p-type amorphous silicon layer (opposite conductivity-type silicon thin film layer 5), and an indium oxide layer (first transparent electrode layer 6), which were formed on its light-incident surface. The collector electrodes 15 were formed on the indium oxide layer.

While the n-type crystalline silicon substrate was provided with an i-type amorphous silicon layer (second intrinsic silicon thin film layer 7), an n-type amorphous silicon layer (one conductivity-type silicon thin film layer 8), an n-type microcrystalline silicon layer (one conductivity-type silicon thin film layer 8), an indium oxide layer (second transparent electrode layer 10), and a copper layer (back electrode layer 11), which were formed on its back surface side. The collector electrode was formed on the copper layer. In sum, the one conductivity-type silicon thin film layer 8 had a two layered structure constituted by the n-type amorphous silicon layer and the n-type microcrystalline silicon layer.

The crystalline silicon solar cell in Example 1 having the structure described above was produced as follows.

The n-type crystalline silicon substrate (one conductivity-type single crystalline silicon substrate 2) having an incident surface whose surface orientation was (100), a thickness of 200 µm, and a size of five inch squared was immersed in 2 wt. percent of an aqueous HF solution for three minutes, so as to remove a silicon oxide film on a surface thereof and be rinsed twice in ultrapure water. Next, the substrate was immersed in 5/15 wt. percent of an aqueous KOH (potassium hydroxide solution)/isopropyl alcohol solution kept at 70 degrees centigrade for 15 minutes, so that the surface of the n-type crystalline silicon substrate was etched to have a convex/concave structure, rinsed twice in ultrapure water, and dried by warm air.

The etched n-type crystalline silicon substrate was introduced into a CVD device, which formed the i-type amorphous silicon layer (first intrinsic silicon thin film layer 3) of 3 nm in thickness on the incident surface.

As to a film thickness of the film-formed thin film, a film forming speed was obtained by measuring a thickness of a film formed on a glass substrate under the same conditions as those in this Example with a spectroscopic ellipsometry and the film thickness was calculated by assuming that the film was formed at the same film forming speed as the above-mentioned case.

The i-type amorphous silicon layer was formed under the conditions of the substrate temperature at 170 degrees centigrade, the pressure at 120 Pa, the flow ratio of SiH₄/H₂ at 3/10, and the supplied power density at 0.011 W/cm². A p-type amorphous silicon layer of 4 nm in thickness was formed on the i-type amorphous silicon layer.

The p-type amorphous silicon layer was formed under the conditions of the substrate temperature at 170 degrees centigrade, the pressure at 60 Pa, the flow ratio of SiH₄/B₂H₆ at 1/3, and the supplied power density at 0.01 W/cm². Herein, the above-mentioned B₂H₆ gas used a gas diluted with H₂ to have a B₂H₆ concentration of 5000 ppm.

Next, an i-type amorphous silicon layer (second intrinsic silicon thin film layer 7) of 6 nm in thickness was formed on the back surface side. The i-type amorphous silicon layer was formed under the conditions of the substrate temperature at 170 degrees centigrade, the pressure at 120 Pa, the flow ratio of SiH₄/H₂ at 3/10, and the supplied power density at 0.011 W/cm².

An n-type amorphous silicon layer (one conductivity-type silicon thin film layer 8) of 4 nm in thickness was formed on the i-type amorphous silicon layer. The n-type amorphous silicon layer was formed under the conditions of the substrate temperature at 170 degrees centigrade, the pressure at 60 Pa, the flow ratio of SiH₄/PH₃ at 1/2, and the supplied power density at 0.01 W/cm². Herein, the above-mentioned PH3 gas used a gas diluted with H₂ to have a PH3 concentration of 5000 ppm.

An n-type microcrystalline silicon layer (one conductivity-type silicon thin film layer 8) of 6 nm in thickness was film-formed on the n-type amorphous silicon layer. The n-type microcrystalline silicon layer was formed under the conditions of the substrate temperature at 170 degrees centigrade, the pressure at 800 Pa, the flow ratio of SiH₄/PH₃/H₂ at 1/5/180, and the supplied power density at 0.08 W/cm².

The n-type crystalline silicon substrate on which the n-type microcrystalline silicon layer had been formed was introduced into a sputtering device, which formed a film of ITO (first transparent electrode layer 6) of 130 nm in thickness on the light-incident side.

Then, ITO (second transparent electrode layer 10) of 100 nm in thickness and Cu (back electrode layer 11) of 250 nm in thickness were formed on the n-type microcrystalline silicon layer of the back surface with the sputtering device.

The ITO had a smooth surface shape and used a sintered body of indium oxide and tin oxide as a sputter target. A mixing ratio of the tin oxide was five wt. percent.
Further, silver paste (second conductive layer 13) was screen-printed on the first transparent electrode layer 6, so as to form comb-shaped electrodes, which served as the collector electrodes 15.

Then, a laser beam was irradiated from the light-incident surface side (collector electrodes 15 side) so as to form a separation groove (cleaving groove 20), thereby removing the outer peripheral part by 0.5 mm by bending and cleaving along the groove.
The laser beam used a third harmonic (wavelength of 355 nm) and formed a cut about one third of the thickness of a wafer in depth, where the substrate was bent and cleaved along the groove by hand.

At this time, the laser beam was irradiated from the light-incident surface of the solar cell as described above, thereby performing dicing with no deviation against the comb-shaped collector electrodes 15.
Finally, annealing was performed at 190 degrees centigrade for one hour (heat treatment step).

In this way, a crystalline silicon solar cell was produced.

Characteristics of the resulting solar cell were measured by irradiation of artificial solar light at an energy density of 100 W/cm² at 25 degrees centigrade with a solar simulator having an AM 1.5 spectrum distribution.

Additionally, a miniature module, containing one of the resulting crystalline silicon solar cells, was produced and left in an environment at a temperature of 85 degrees centigrade and a humidity of 85 percent for 1000 hours to undergo an environment test.

The miniature module had a structure constituted by the back sheet, the sealing member, the crystalline silicon solar cell with the wiring members connected, the sealing member, and the glass. The miniature module was connected to an external measuring instrument via the wiring members attached to the crystalline silicon solar cell and underwent a measurement of the characteristics of the solar cell with the above-mentioned solar simulator.

An output of the solar cell obtained before the environment test was compared to that obtained after the test, and the test result was judged to be successful if the retention = (output after the environment test) / (output before the environment test) ^{∗} 100 ≥ 94.0 (%) was satisfied.

### (Comparative Example 1)

A solar cell was produced by the same method as that in Example 1 except that the laser beam was irradiated from the back surface side (back electrode layer 11 side).

### (Reference Example 1)

A solar cell was produced by the same method as that in Example 1 except that the laser beam was irradiated from the back surface side (back electrode layer 11 side) and that Ag of 250 nm in thickness instead of Cu was formed by a sputtering method as the back electrode layer 11.

### (Reference Example 2)

A solar cell was produced by the same method as that in Example 1 except that Ag of 250 nm in thickness instead of Cu was formed by a sputtering method as the back electrode layer 11.

### (Example 2)

In the producing steps in Example 1, the laser beam was irradiated from the light-incident surface side (collector electrodes 15 side), so as to cut off the outer peripheral part by 0.5 mm. In other words, only the laser irradiation step cut off the outer peripheral part by 0.5 mm without performing the cleaving step of the producing step in Example 1. At this time, the laser beam was, as described above, irradiated from the light-incident surface side of the solar cell, thereby performing dicing with no deviation against the comb-shaped collector electrodes 15. Finally, annealing was performed at 190 degrees centigrade for one hour (heat treatment step) in the same manner as Example 1.

### (Comparative Example 2)

A solar cell was produced by the same method as that in Example 2 except that the laser beam was irradiated from the back surface side (back electrode layer 11 side).

### (Example 3)

In the producing steps in Example 2, ITO (second transparent electrode layer 10) of 80 nm in thickness was formed as a film. Further, this Example employed not a single copper layer, but a stacked layer structure of silver and copper as the back electrode layer 11. Specifically, silver (first conductive layer 12) of 150 nm in thickness and copper (second conductive layer 13) of 300 nm in thickness were formed on the ITO (second transparent electrode layer 10) of the back surface with the sputtering device in the producing steps in Example 2. The rest of the steps were the same as those in Example 2.

### (Comparative Example 3)

A solar cell was produced by the same method as that in Example 3 except that the laser beam was irradiated from the back surface side (back electrode layer 11 side).

Tables 5 to 8 respectively show photoelectric conversion characteristics of the solar cells in the Examples, Comparative Examples, and Reference Examples described above and retentions of those characteristics after an environmental test.

### [TABLE 5]

**TABLE 5**

| INITIAL STAGE | BACK ELECTRODE LAYER | LASER IRRADIATION | SOLAR CELL CHARACTERISTICS | | | |
|---|---|---|---|---|---|---|
| | | | JSC (mA/cm2) | VOC (V) | FF (%) | Eff (%) |
| REFERENCE EXAMPLE 1 | Ag | BACK | 36.27 | 0.730 | 71.41 | 18.91 |
| REFERENCE EXAMPLE 2 | Ag | INCIDENT | 36.25 | 0.729 | 70.88 | 18.73 |
| COMPARATIVE EXAMPLE 1 | Cu | BACK | 36.19 | 0.728 | 71.30 | 18.78 |
| EXAMPLE 1 | Cu | INCIDENT | 36.20 | 0.732 | 70.65 | 18.72 |

### [TABLE 6]

**TABLE 6**

| AFTER 1000 HOURS | BACK ELECTRODE LAYER | LASER IRRADIATION | SOLAR CELL CHARACTERISTICS | | | | RETENTION (PERCENT) | | | |
|---|---|---|---|---|---|---|---|---|---|---|
| | | | JSC (mA/cm2) | VOC (V) | FF (%) | Eff (%) | JSC (mA/cm2) | VOC (V) | FF (%) | Eff (%) |
| REFERENCE EXAMPLE 1 | Ag | BACK | 36.24 | 0.726 | 67.70 | 17.81 | 99.9 | 99.5 | 94.8 | 94.2 |
| REFERENCE EXAMPLE 2 | Ag | INCIDENT | 36.23 | 0.727 | 67.25 | 17.71 | 99.9 | 99.7 | 94.9 | 94.6 |
| COMPARATIVE EXAMPLE 1 | Cu | BACK | 36.10 | 0.720 | 67.59 | 17.57 | 99.8 | 98.9 | 94.8 | 93.5 |
| EXAMPLE 1 | Cu | INCIDENT | 36.18 | 0.728 | 67.10 | 17.67 | 99.9 | 99.5 | 95.0 | 94.4 |

### [TABLE 7]

**TABLE 7**

| INITIAL STAGE | BACK ELECTRODE LAYER | LASER IRRADIATION (CUT BY LASER) | SOLAR CELL CHARACTERISTICS | | | |
|---|---|---|---|---|---|---|
| | | | JSC (mA/cm2) | VOC (V) | FF (%) | Eff (%) |
| COMPARATIVE EXAMPLE 2 | Ag/Cu | BACK | 36.32 | 0.729 | 71.52 | 18.94 |
| EXAMPLE 2 | Ag/Cu | INCIDENT | 36.33 | 0.730 | 70.85 | 18.79 |
| COMPARATIVE EXAMPLE 3 | Cu | BACK | 36.22 | 0.726 | 71.33 | 18.76 |
| EXAMPLE 3 | Cu | INCIDENT | 36.24 | 0.727 | 70.82 | 18.66 |

### [TABLE 8]

**TABLE 8**

| AFTER 1000 HOURS | BACK ELECTRODE LAYER | LASER IRRADIATION (CUT BY RASER) | SOLAR CELL CHARACTERISTICS | | | | RETENTION (%) | | | |
|---|---|---|---|---|---|---|---|---|---|---|
| | | | JSC (mA/cm2) | VOC (V) | FF (%) | Eff (%) | JSC (mA/cm2) | VOC (V) | FF (%) | Eff (%) |
| COMPARATIVE EXAMPLE 2 | Ag/Cu | BACK | 36.28 | 0.721 | 67.75 | 17.72 | 99.9 | 98.9 | 94.7 | 93.6 |
| EXAMPLE 2 | Ag/Cu | INCIDENT | 36.30 | 0.727 | 67.32 | 17.77 | 99.9 | 99.6 | 95.0 | 94.5 |
| COMPARATIVE EXAMPLE 3 | Cu | BACK | 36.18 | 0.719 | 67.58 | 17.58 | 99.9 | 99.0 | 94.7 | 93.7 |
| EXAMPLE 3 | Cu | INCIDENT | 36.20 | 0.725 | 67.22 | 17.64 | 99.9 | 99.7 | 94.9 | 94.6 |

First, Example 1, Comparative Example 1, and Reference Examples 1 and 2, each of which had the cleaving step, will be examined, making reference to Tables 5 and 6.
As shown in Table 5, comparing data for all of the Examples in the initial stages before the environmental tests, Example 1 and Reference Example 2, which performed laser irradiation from the light-incident surface side (collector electrodes 15 side), had slightly lowered values of FF than those of Comparative Example 1 and Reference Example 1, which performed laser irradiation from the back surface side (back electrode layer 11 side).

It is thought that this was because the laser irradiation damaged the p-n junction existing on the light-incident surface side and that the values of FF dropped due to a leakage current.

Next, according to Table 6, comparing data after the environmental tests, Comparative Example 1 using copper (Cu) for the back electrode layer 11 and performing the laser irradiation from the back surface side had a considerably lowered value of Voc.
It is thought that this was because copper (Cu) stuck to the end part of the silicon substrate 2 in the laser irradiation gradually diffused into the silicon substrate 2 by the environmental test and formed a recombination center, which lowered the values of Voc.

According to the results, the retention of conversion efficiency after the environmental test in only Comparative Example 1 fell below 94 percent and failed the test. In contrast, as seen from the result of Example 1 after the environmental test, it showed substantially the same level of conversion efficiency as in the case of using Ag for the back electrode layer 11.

The above results revealed that the laser irradiation for dicing from the light-incident surface side suppressed the deterioration of the solar cell characteristics after the environmental test when Cu was used as a major ingredient of the back electrode layer 11, so that solar cells substantially equivalent to those produced by using Ag as the back electrode layer are produced at a lower cost.

Next, Examples 2 and 3 and Comparative Examples 2 and 3, in which the outer peripheral part was cut off only by the laser irradiation step without the cleaving step, will be examined.

As shown in Table 7, as comparing data in the initial stage before the environmental tests in all Examples, Examples 2 and 3 performing the laser irradiation from the light-incident surface side (collector electrodes 15 side) had slightly lowered values of FF than those of Comparative Examples 2 and 3 performing laser irradiation from the back surface side (back electrode layer 11 side).
It is thought that this was because the laser irradiation damaged the p-n junction existing on the light-incident surface side and the values of FF dropped due to a leakage current.

Next, according to Table 8, comparing data after the environmental tests, Comparative Example 3 using copper (Cu) for the back electrode layer 11 and performing the laser irradiation from the back surface side had a considerably lowered value of Voc.
Similarly, Comparative Example 2 using copper (Cu) and silver (Ag) for the back electrode layer 11 and performing laser irradiation from the back surface side had a considerably lowered value of Voc.

It is thought that both of these were because copper (Cu) stuck to the end part of the silicon substrate 2 in the laser irradiation gradually diffused into the silicon substrate 2 by the environmental test and formed a recombination center, which lowered the values of Voc.

According to the results, the retentions of conversion efficiency after the environmental tests in Comparative Examples 2 and 3 fell below 94 percent and failed the test. In contrast, the retentions in Examples 2 and 3 after the environmental tests exceeded 94 percent.

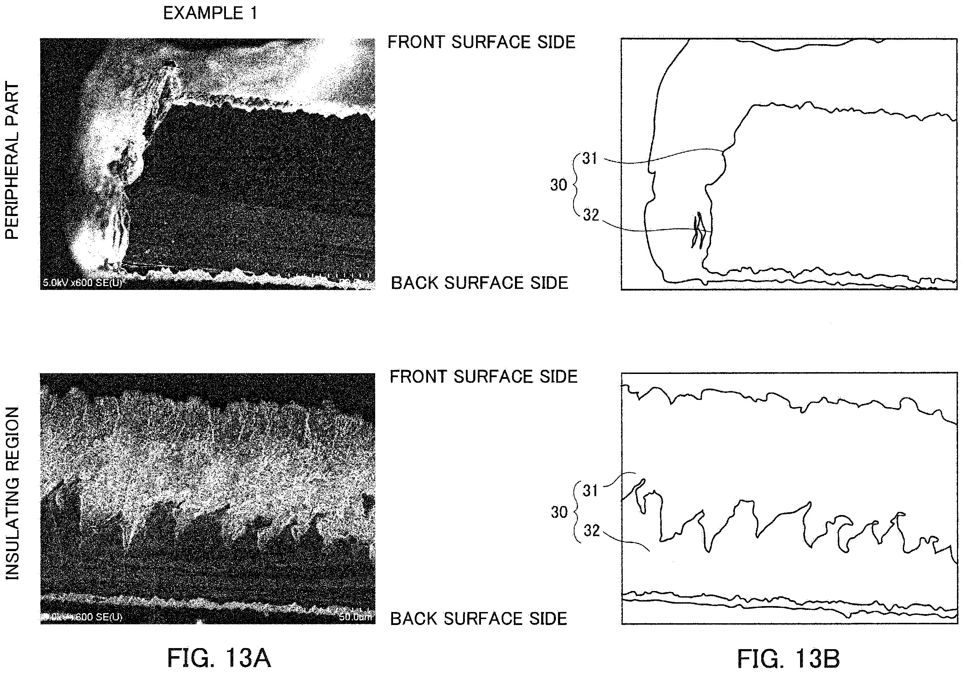

Next, cross sectional structures of Examples 1 and 2 and Comparative Examples 1 and 2 will be considered below.
In the crystalline silicon solar cell in Example 1, the insulating region 30, as seen from Fig. 13, had the first region 31 inclining downward from the light-incident surface side toward the back surface side and the second region 32, which was continuous to the first region 31, extending in a substantially vertical direction.

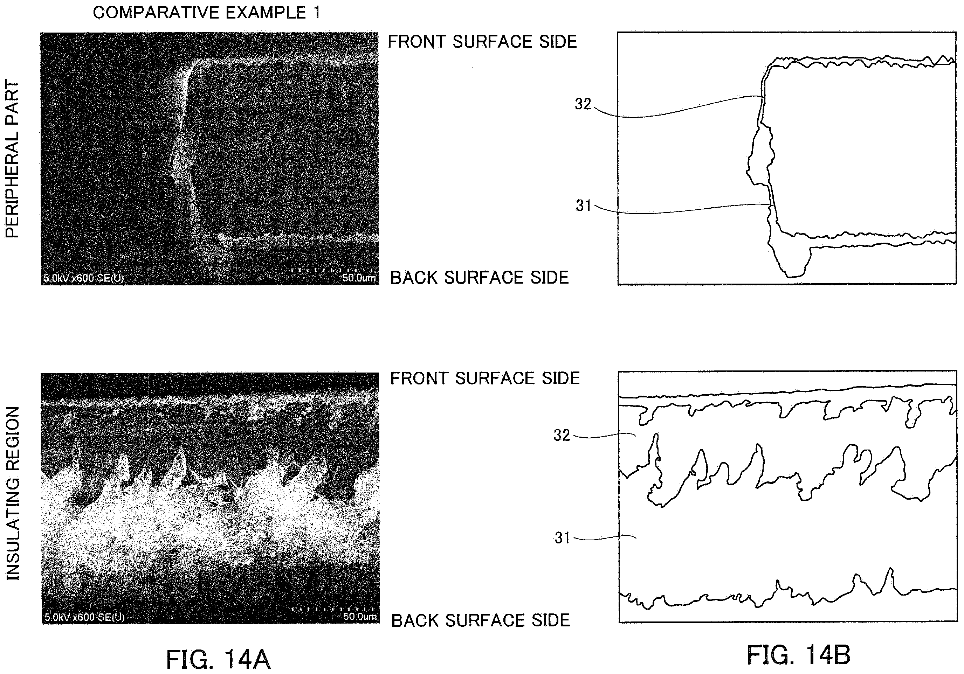

In contrast, in the crystalline silicon solar cell in Comparative Example 1, the insulating region 30, as seen from Fig. 14, had the second region 32 extending in a substantially vertical direction from the light-incident surface side toward the back surface side and the first region 31, which was continuous to the second region 32, inclining downward.
Moreover, in Example 1 and Comparative Example 1, the first region 31 formed by laser irradiation and the second region 32 formed by cleaving are obviously different in surface structure.

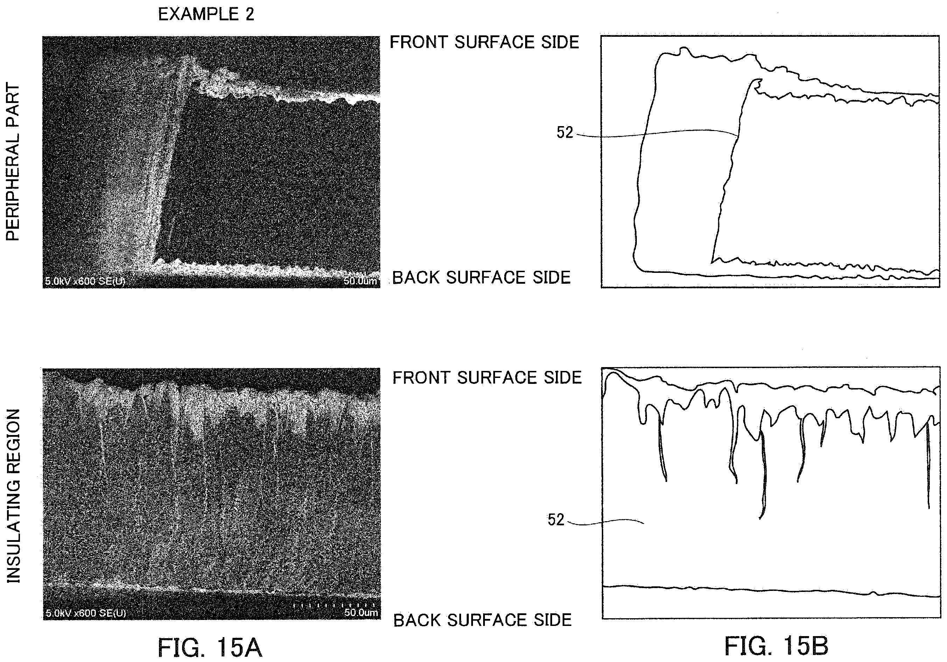

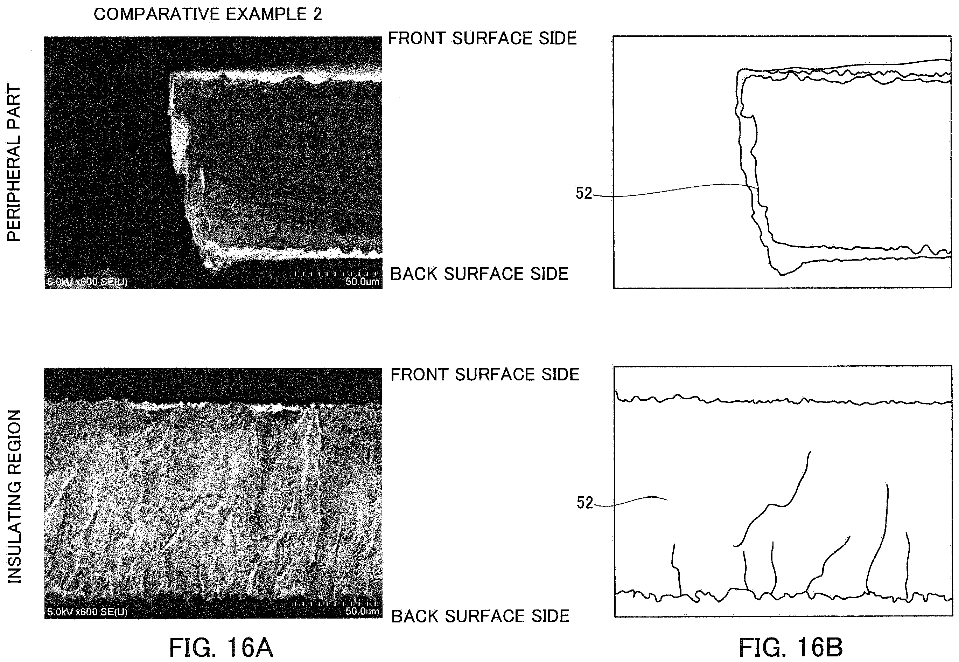

In the crystalline silicon solar cell in Example 2, the insulating region 51, as seen from Fig. 15, had the first region 52 inclining downward from the light-incident surface side toward the back surface side. Further, the crystalline silicon solar cell in Example 2 had many cracks occurring from the light-incident surface side.
In contrast, in the crystalline silicon solar cell in Comparative Example 2, the insulating region 51, as seen from Fig. 16, had the first region 52 inclining upward from the light-incident surface side toward the back surface side. Further, the crystalline silicon solar cell in Comparative Example 2 had many cracks occurring from the back surface side.

As described above, the the method for producing a crystalline silicon solar cell according to the present invention can provide solar cells with high reliability and a high output power at low cost.

### DESCRIPTION OF NUMERALS

1., 50. crystalline silicon solar cell
2. one conductivity-type single crystalline silicon substrate (silicon substrate)
3. first intrinsic silicon thin film layer
5. opposite conductivity-type silicon thin film layer (light-incident side silicon thin film layer)
6. first transparent electrode layer (light-incident side transparent electrode layer)
7. second intrinsic silicon thin film layer
8. one conductivity-type silicon thin film layer (back surface side silicon thin film layer)
10. second transparent electrode layer (back surface side transparent electrode layer)
11. back electrode layer (back electrode)
12. first conductive layer
13. second conductive layer
20. cleaving groove
21. cleaved surface
25. first main surface-side electrode layer
25. second main surface-side electrode layer
27. photoelectric conversion section
30., 51. insulating region
31., 52. first region
32. second region
40. solar cell module
42. glass substrate (sealing member)
43. back sheet (sealing member)
53. groove

## Claims

1. A method for producing a crystalline silicon solar cell (1),
wherein the crystalline silicon solar cell comprises a one conductivity-type single crystalline silicon substrate (2), a first main surface, a second main surface, and an outer peripheral part,
wherein the substrate has an outer peripheral end face, and
wherein the crystalline silicon solar cell further comprises:
a first intrinsic silicon thin film layer (3), an opposite conductivity-type silicon thin film layer (5), and a first transparent electrode layer (6) provided on the first main surface side of the substrate in this order; and
a second intrinsic silicon thin film layer (7), a one conductivity-type silicon thin film layer (8), a second transparent electrode layer (10), and a back electrode layer (11) provided on the second main surface side of the substrate in this order,
the method comprising the steps of:
a first transparent electrode layer forming step of forming the first transparent electrode layer (6) on the opposite conductivity-type silicon thin film layer (5),
a back electrode layer forming step of forming the back electrode layer containing more than 50% copper on the entire area of the surface of the second main surface side of the substrate, and
an insulating step of forming an insulating region so as to remove a short circuit between at least the first transparent electrode layer (6) on the first main surface side and at least the second transparent electrode layer (10) and the back electrode layer (11) on the second main surface side after the steps of the first transparent electrode layer forming step and the back electrode layer forming step,
the insulating step including a laser irradiation step of irradiating a laser beam along an entire periphery of the outer peripheral part of the first main surface from the first main surface side onto a position within 3 mm from the outer peripheral end face of the one conductivity-type single crystalline silicon substrate,
**characterized in that**
(i) the laser irradiation step irradiates the laser beam so as to form a bottomed groove along the entire periphery of the outer peripheral part of the first main surface, wherein the depth of the bottomed groove is one quarter or more of the thickness of the silicon substrate, and
the insulating step includes a cleaving step of bending and cleaving to remove an unnecessary part along the bottomed groove after the laser irradiation step; or
(ii) the laser irradiation step cuts off an unnecessary part by irradiating the laser beam from the first main surface side to reach the second main surface side, thereby forming the insulating region.

2. The method for producing a crystalline silicon solar cell as defined in claim 1,
wherein the insulating region physically divides an electrical connection between at least the first transparent electrode layer and at least the second transparent electrode layer and the back electrode layer.

3. The method for producing a crystalline silicon solar cell as defined in claim 1 or 2, further comprising the steps of:
a first main surface setting step of setting the one conductivity-type single crystalline silicon substrate (2) on a substrate stage so that a face of the first main surface side is exposed,
a first intrinsic silicon thin film layer forming step of forming the first intrinsic silicon thin film layer (3) on the first main surface side, and
a first silicon thin film layer forming step of forming the opposite conductivity-type silicon thin film layer (5), and
the first main surface setting step, the first intrinsic silicon thin film layer forming step, the first silicon thin film layer forming step, and the first transparent electrode layer forming step being performed in this order.

4. The method for producing a crystalline silicon solar cell as defined in one of claims 1 to 3 comprising performing a heat treatment step of annealing the insulating region after the insulating step.

5. The method for producing a crystalline silicon solar cell as defined in one of claims 1 to 4 comprising forming at least one electrode layer selected from a group consisting of the first transparent electrode layer (6), the second transparent electrode layer (10), and the back electrode layer (11), the at least one electrode layer being provided on one main surface side, so that a part of the at least one electrode layer extends around to the other main surface side.

6. The method for producing a crystalline silicon solar cell as defined in one of claims 1 to 5,
comprising forming the back electrode layer (11) by a first conductive layer (12) and a second conductive layer (13) containing more than 50% copper in this order from the second transparent electrode layer side,
wherein the first conductive layer (12) is formed of a conductive material with a high density and formed on the entire area of the surface of the second main surface side of the second transparent electrode layer, and
wherein the second conductive layer (13) is formed on the entire area of the surface of the second main surface side of the first conductive layer.

7. A method for producing a solar cell module,
comprising a step of forming a crystalline silicon solar cell by the method for producing a crystalline silicon solar cell as defined in one of claims 1 to 6, and
the solar cell module being formed by electrically connecting a plurality of crystalline silicon solar cells in series or in parallel.

## Patentansprüche

1. Verfahren zur Herstellung einer kristallinen Silicium-Solarzelle (1),
worin die kristalline Silicium-Solarzelle ein Einkristall-Siliciumsubstrat mit Leitfähigkeit von einem Typ (2), eine erste Hauptoberfläche, eine zweite Hauptoberfläche und einen äußeren Umfangsteil umfasst,
worin das Substrat eine äußere Umfangs-Endfläche aufweist und
worin die kristalline Silicium-Solarzelle ferner umfasst:
eine erste intrinsische Silicium-Dünnfilmschicht (3), eine Silicium-Dünnfilmschicht vom entgegengesetzten Leitfähigkeitstyp (5), und eine erste transparente Elektrodenschicht (6), vorgesehen auf der ersten Hauptoberflächenseite des Substrats in dieser Reihenfolge; und
eine zweite intrinsische Silicium-Dünnfilmschicht (7), eine Silicium-Dünnfilmschicht mit Leitfähigkeit von einem Typ (8), eine zweite transparente Elektrodenschicht (10) und eine Rückelektrodenschicht (11), die auf der zweiten Hauptoberflächenseite des Substrats in dieser Reihenfolge vorgesehen sind,
wobei das Verfahren die Schritte umfasst:
einen erste transparente Elektrodenschicht-Bildungsschritt zum Bilden der ersten transparenten Elektrodenschicht (6) auf der Silicium-Dünnfilmschicht vom entgegengesetzten Leitfähigkeitstyp (5),
einen Rückelektrodenschicht-Bildungsschritt zum Bilden der Rückelektrodenschicht, enthaltend mehr als 50 % Kupfer, auf der Gesamtfläche der Oberfläche der zweiten Hauptoberflächenseite des Substrats, und
einen Isolierungsschritt zum Bilden eines isolierenden Bereichs, um so einen Kurzschluss zwischen zumindest der ersten transparenten Elektrodenschicht (6) auf der ersten Hauptoberflächenseite und zumindest der zweiten transparenten Elektrodenschicht (10) und der Rückelektrodenschicht (11) auf der zweiten Hauptoberflächenseite zu entfernen, nach den Schritten des ersten transparenten Elektrodenschicht-Bildungsschritts und des Rückelektroden-Bildungsschritts,
wobei der Isolierungsschritt einen Laserbestrahlungsschritt zum Bestrahlen eines Laserstrahls entlang des gesamten Umfangs des äußeren Umfangsteils der ersten Hauptoberfläche von der ersten Hauptoberflächenseite bis zu einer Position innerhalb von 3 mm von der äußeren Umfangs-Endfläche des Einkristall-Siliciumsubstrat mit Leitfähigkeit von einem Typ umfasst,
**dadurch gekennzeichnet, dass**
(i) der Laserbestrahlungsschritt den Laserstrahl so strahlt, dass eine einen Boden aufweisende Rille entlang des gesamten Umfangs des äußeren Umfangsteils der ersten Hauptoberfläche gebildet wird, worin die Tiefe der den Boden aufweisenden Rille ein Viertel oder mehr der Dicke des Siliciumsubstrats beträgt, und
der Isolierungsschritt einen Abspaltungsschritt zum Biegen und Abspalten umfasst, um einen nicht notwendigen Teil entlang der den Boden aufweisenden Rille nach dem Laserbestrahlungsschritt zu entfernen; oder
(ii) der Laserbestrahlungsschritt einen nicht notwendigen Teil durch Bestrahlen mit dem Laserstrahl von der ersten Hauptoberflächenseite abschneidet, um die zweite Hauptoberflächenseite zu erreichen, wodurch der isolierende Bereich gebildet wird.

2. Verfahren zur Herstellung einer kristallinen Silicium-Solarzelle gemäß Anspruch 1,
worin der Isolierungsbereich eine elektrische Verbindung zwischen zumindest der ersten transparenten Elektrodenschicht und zumindest der zweiten transparenten Elektrodenschicht und der Rückelektrodenschicht unterbricht.

3. Verfahren zur Herstellung einer kristallinen Silicium-Solarzelle gemäß Anspruch 1 oder 2, ferner umfassend die Schritte:
einen ersten Hauptoberflächen-Setzschritt zum Setzen des Einkristall-Siliciumsubstrats vom Typ mit einer Leitfähigkeit (2) auf einen Substrathalter, so dass eine Fläche der ersten Hauptoberflächenseite freiliegt,
einen ersten intrinsischen Silicium-Dünnfilmschicht-Bildungsschritt zum Bilden der ersten intrinsischen Silicium-Dünnfilmschicht (3) auf der ersten Hauptoberflächenseite, und
einen ersten Silicium-Dünnfilmschicht-Bildungsschritt zum Bilden der Silicium-Dünnfilmschicht vom entgegengesetzten Leitfähigkeitstyp (5) und
worin der erste Hauptoberflächen-Setzschritt, der erste intrinsische Silicium-Dünnfilmschicht-Bildungsschritt, der erste Silicium-Dünnfilmschicht-Bildungsschritt und der erste transparente Elektrodenschicht-Bildungsschritt in dieser Reihenfolge durchgeführt werden.

4. Verfahren zur Herstellung einer kristallinen Silicium-Solarzelle gemäß irgendeinem der Ansprüche 1 bis 3, umfassend das Durchführen eines Wärmebehandlungsschitts zum Tempern des isolierenden Bereichs nach dem Isolierungsschritt.

5. Verfahren zur Herstellung einer kristallinen Silicium-Solarzelle gemäß irgendeinem der Ansprüche 1 bis 4, umfassend das Bilden von zumindest einer Elektrodenschicht, ausgewählt aus der Gruppe, bestehend aus der ersten transparenten Elektrodenschicht (6), der zweiten transparenten Elektrodenschicht (10) und der Rückelektrodenschicht (11), wobei die zumindest eine Elektrodenschicht auf einer Hauptoberflächenseite vorgesehen ist, so dass ein Teil der zumindest einen Elektrodenschicht sich bis zur anderen Hauptoberflächenseite erstreckt.

6. Verfahren zur Herstellung einer kristallinen Silicium-Solarzelle gemäß irgendeinem der Ansprüche 1 bis 5,
umfassend das Bilden der Rückelektrodenschicht (11) durch eine erste leitfähige Schicht (12) und eine zweite leitfähige Schicht (13), enthaltend mehr als 50 % Kupfer, in dieser Reihenfolge von der Seite der zweiten transparenten Elektrodenschicht,
worin die erste leitfähige Schicht (12) aus einem leitfähigen Material mit hoher Dichte gebildet ist und auf der Gesamtfläche der Oberfläche der zweiten Hauptoberflächenseite der zweiten transparenten Elektrodenschicht gebildet ist, und
worin die zweite leitfähige Schicht (13) auf der Gesamtfläche der Oberfläche der zweiten Hauptoberflächenseite der ersten leitfähigen Schicht gebildet ist.

7. Verfahren zur Herstellung eines Solarzellenmoduls,
umfassend einen Schritt zum Bilden einer kristallinen Silicium-Solarzelle durch das Verfahren zur Herstellung einer kristallinen Silicium-Solarzelle, wie es in irgendeinem der Ansprüche 1 bis 6 definiert ist, und
wobei das Solarzellenmodul gebildet wird durch serielles oder paralleles elektrisches Verbinden einer Vielzahl von kristallinen Silicium-Solarzellen.

## Revendications

1. Procédé pour produire une cellule solaire à silicium cristallin (1),
dans lequel la cellule solaire à silicium cristallin comprend un substrat de silicium monocristallin à un seul type de conductivité (2), une première surface principale, une seconde surface principale et une partie périphérique extérieure,
dans lequel le substrat a une face d'extrémité périphérique extérieure, et
dans lequel la cellule solaire à silicium cristallin comprend en outre :
une première couche à film mince de silicium intrinsèque (3), une couche à film mince de silicium à type de conductivité opposée (5), et une première couche d'électrode transparente (6) disposées sur le premier côté de surface principale du substrat dans cet ordre ; et
une seconde couche à film mince de silicium intrinsèque (7), une couche à film mince de silicium à un seul type de conductivité (8), une seconde couche d'électrode transparente (10) et une couche d'électrode arrière (11) disposées sur le second côté de surface principale du substrat dans cet ordre,
le procédé comprenant les étapes de :
une étape de formation de première couche d'électrode transparente consistant à former la première couche d'électrode transparente (6) sur la couche à film mince de silicium à type de conductivité opposée (5),
une étape de formation de couche d'électrode arrière consistant à former une couche d'électrode arrière contenant plus de 50 % de cuivre sur la zone entière de la surface du second côté de surface principale du substrat, et
une étape d'isolation consistant à former une région d'isolation afin de supprimer un court-circuit entre au moins la première couche d'électrode transparente (6) sur le premier côté de surface principale et au moins la seconde couche d'électrode transparente (10) et la couche d'électrode arrière (11) sur le second côté de surface principale après les étapes de l'étape de formation de première couche d'électrode transparente et l'étape de formation de couche d'électrode arrière,
l'étape d'isolation incluant une étape d'irradiation laser consistant à irradier un faisceau laser le long d'une périphérie entière de la partie périphérique extérieure de la première surface principale à partir du premier côté de surface principale sur une position dans les limites de 3 mm à partir de la face d'extrémité périphérique extérieure du substrat de silicium cristallin d'un seul type de conductivité,
**caractérisé en ce que**
(i) l'étape d'irradiation laser irradie le faisceau laser de façon à former une rainure avec fond le long de la périphérie entière de la partie périphérique extérieure de la première surface principale, dans laquelle la profondeur de la rainure avec fond fait un quart ou plus de l'épaisseur du substrat de silicium, et
l'étape d'isolation inclut une étape de clivage consistant à courber et cliver pour enlever une partie inutile le long de la rainure avec fond après l'étape d'irradiation laser ; ou
(ii) l'étape d'irradiation laser coupe une partie inutile en irradiant le faisceau laser à partir du premier côté de surface principale pour atteindre le second côté de surface principale, formant de ce fait la région d'isolation.

2. Procédé pour produire une cellule solaire à silicium cristallin tel que défini dans la revendication 1,
dans lequel la région d'isolation divise physiquement une connexion électrique entre au moins la première couche d'électrode transparente et au moins la seconde couche d'électrode transparente et la couche d'électrode arrière.

3. Procédé pour produire une cellule solaire à silicium cristallin tel que défini dans la revendication 1 ou 2, comprenant en outre les étapes suivantes :
une étape de positionnement de première surface principale consistant à positionner le substrat de silicium monocristallin à un seul type de conductivité (2) sur un étage de substrat de sorte qu'une face du premier côté de surface principale est exposée,
une étape de formation de première couche à film mince de silicium intrinsèque consistant à former la première couche à film mince de silicium intrinsèque (3) sur le premier côté de surface principale, et
une étape de formation de première couche à film mince de silicium consistant à former la couche à film mince de silicium à type de conductivité opposée (5), et
l'étape de positionnement de première surface principale, l'étape de formation de première couche à film mince de silicium intrinsèque, l'étape de formation de première couche à film mince de silicium et l'étape de formation de première couche d'électrode transparente étant effectuées dans cet ordre.

4. Procédé pour produire une cellule solaire à silicium cristallin tel que défini dans l'une des revendications 1 à 3 comprenant l'exécution d'une étape de traitement thermique consistant à recuire la région d'isolation après l'étape d'isolation.

5. Procédé pour produire une cellule solaire à silicium cristallin tel que défini dans l'une des revendications 1 à 4 comprenant la formation d'au moins une couche d'électrode sélectionnée parmi un groupe consistant en la première couche d'électrode transparente (6), la seconde couche d'électrode transparente (10) et la couche d'électrode arrière (11), l'au moins une couche d'électrode étant disposée sur un côté particulier de surface principale, de sorte qu'une partie de l'au moins une couche d'électrode s'étend autour de l'autre côté de surface principale.

6. Procédé pour produire une cellule solaire à silicium cristallin tel que défini dans l'une des revendications 1 à 5,
comprenant la formation de la couche d'électrode arrière (11) par une première couche conductrice (12) et une seconde couche conductrice (13) contenant plus de 50 % de cuivre dans cet ordre à partir du côté de seconde couche d'électrode transparente,
dans lequel la première couche conductrice (12) est formée d'une matière conductrice avec une densité élevée et formée sur la zone entière de la surface du second côté de surface principale de la seconde couche d'électrode transparente, et
dans lequel la seconde couche conductrice (13) est formée sur la zone entière de la surface du second côté de surface principale de la première couche conductrice.

7. Procédé pour produire un module de cellule solaire,
comprenant une étape consistant à former une cellule solaire à silicium cristallin par le procédé pour produire une cellule solaire à silicium cristallin tel que défini dans l'une des revendications 1 à 6, et
le module de cellule solaire étant formé en connectant électriquement une pluralité de cellules solaires à silicium cristalline en série ou en parallèle.
